(19) Europäisches Patentamt
European Patent Office
Office européen des brevets

(11) EP 2 166 395 A1

(12) EUROPEAN PATENT APPLICATION
published in accordance with Art. 153(4) EPC

(43) Date of publication:
**24.03.2010 Bulletin 2010/12**

(21) Application number: **08777385.9**

(22) Date of filing: **19.06.2008**

(51) Int Cl.:
***G02B 7/02*** *(2006.01)* ***G02B 1/04*** *(2006.01)*
***H01L 27/14*** *(2006.01)* ***H04N 5/225*** *(2006.01)*
***H04N 5/335*** *(2006.01)*

(86) International application number:
**PCT/JP2008/061224**

(87) International publication number:
**WO 2009/004929 (08.01.2009 Gazette 2009/02)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **03.07.2007 JP 2007175152**

(71) Applicant: **Konica Minolta Opto, Inc.**
**Hachioji-shi, Tokyo 192-8505 (JP)**

(72) Inventors:
- **WATANABE, Daisuke**
  **Hachioji-shi**
  **Tokyo 192-8505 (JP)**
- **KOJIMA, Takeshi**
  **Hachioji-shi**
  **Tokyo 192-8505 (JP)**

(74) Representative: **Henkel, Feiler & Hänzel**
**Patentanwälte**
**Maximiliansplatz 21**
**80333 München (DE)**

# (54) IMAGING DEVICE MANUFACTURING METHOD, IMAGING DEVICE AND OPTICAL ELEMENT

(57) Provided is an imaging device manufacturing method wherein an optical element is prevented from deforming due to reflow process. The manufacturing method is provided with a step of forming the optical element by curing a thermosetting resin material having a viscosity of 50-50,000mPas under measuring conditions at 23°C and 500Hz; a step of placing the optical element on a substrate with an electronic component; and a step of performing reflow process to the optical element, the electronic component and the substrate, and mounting the optical element and the electronic component on the substrate.

EP 2 166 395 A1

## Description

### TECHNICAL FIELD

The present invention relates to a manufacturing method of an image pick-up device, particularly to a manufacturing method of image pick-up device in which an optical element is mounted together with electronic parts by reflow process, an image pick-up device obtained by the method and an optical element used in the method.

### BACKGROUND OF THE INVENTION

An inorganic glass material is generally employed for an optical element (mainly lens) in view of excellent optical property, mechanical strength etc., hitherto. Miniaturization of an optical element is required with progress of a device using the optical element, and it becomes difficult to produce an inorganic glass material having large curvature (R) or complicated shape because of a problem of production processability. An optical element using the inorganic glass is heavy and needs higher driving voltage when it is driven because the inorganic glass material has larger gravity than a plastic material.

Plastic materials easy for processing and low gravity have been investigated and practiced. Plastic materials for an optical element include thermoplastic resin having good transparency such as polymethylmethacrylate, polycarbonate and polystyrene. The production cost can be markedly reduced because a mould for the plastics has very longer life time than for the inorganic glass material.

A production method of an electronics module with lower cost is developed in which metal paste (such as solder paste) is preliminarily potted, then circuit substrate provided with electronic parts is subjected to reflow process (thermal process) in case that electronic parts such as IC (Integrated Circuits) chips are mounted on a circuit substrate. (See, Patent Document 1).

A further improvement of production efficiency is recently required in a production system of the image pick-up device, by employing the solder reflow process for the circuit substrate provided with the optical element in addition to the electronic parts in integrate form.

The plastic optical element, which can be produced with low cost, is naturally required for the optical module produced by a production system to which the reflow process is introduced, in place of an expensive glass optical element.

The resin material conventionally used for an optical element has good processing ability because it is softened and molt at relatively low temperature, however, has a defect that the formed optical element is apt to deform by heat. The optical element as itself is exposed to a heating condition at 260°C when the electronic parts provided with the optical element is mounted on the substrate by the solder reflow process. The optical element composed of the thermoplastic resin is problematic due to causing shape deterioration.

The present inventors have investigated application of thermosetting resins such as an epoxy type resin (See Patent Documents 2 and 3) and a silicone type resin (See Patent Document 4) as a plastic material used for the optical element for an image pick-up element produced by the reflow process. The thermosetting resin shows liquid or fluid before curing and curable by heating, and has good production processability same as the thermoplastic resin. It is hardly molten by heat after curing same as the thermoplastic resin and deformation by heat is little.

Patent Document 1 JP-A 2001-24320
Patent Document 2 JP-A H11-74420
Patent Document 3 JP-A 2004-307011
Patent Document 4 JP-A 2004-186168

### DESCRIPTION OF THE INVENTION

### PROBLEM TO BE DISSOLVED BY THE INVENTION

However, when the thermosetting resin as disclosed in the above described Patent Documents 2 to 4 is employed, it has been found that the optical element to be formed has low resin density and deforms by the reflow process in case the pressure (injection pressure) is low at a time of moulding resulting insufficient filling amount. On the other hand, it has been also found that when the pressure at a time of moulding is made high, resin material leaks from the mould and sufficient pressure can not be applied in a forming process resulting deformation by the reflow process. In case that the viscosity of the resin material is set too high so as to prevent the leak of resin material from the mould, fluidity of the resin material becomes low, and resin material is cured as a result, and there is a case that a deformation occurs when the distortion is dissolved by a reflow process. Though deformation is not be problematic when applied to an adhesion employing the thermosetting resin or in the fields of thin film coat etc., it is problematic when used in a

precision device such as an optical element for a light pick-up device, optical element for pick-up device etc.

The object of the resent invention is to provide a manufacturing method of image pick-up device to prevent deformation of an optical element by a reflow process, and the another object is to provide an image pick-up device obtained by the manufacturing method and an optical element for the manufacturing method suitably.

## TECHNICAL MEANS TO DISSOLVE THE PROBLEM

In accordance with one of the embodiments of the present invention, a manufacturing method of an image pick-up device is provided comprising;
a step of forming an optical element by curing a thermosetting resin material having viscosity of 50 to 50,000 mPa·s under measuring condition at 23 °C and 500 Hz,
a step of placing an optical element and electronic parts on a substrate, and
a step of performing a reflow process to the optical element, the electronic parts and the substrate so as to mount the electronic parts and the substrate on the above mentioned substrate.

The image pick-up device manufactured by the manufacturing method of above described image pick-up device is preferably provided according to another embodiment of the present invention.

In accordance with the other embodiment of the present invention, an optical element is provided, wherein the optical element
is formed by curing a thermosetting resin material having viscosity of 50 to 50,000 mPa·s under measuring condition at 23 °C and 500 Hz, and
is to be used in a manufacturing method in which the optical element as well as the electronic parts are mounted on the substrate by a reflow process in a state that the optical element as well as the electronic parts are placed on the substrate.

## ADVANTAGE OF THE INVENTION

Since the optical element is formed by using a thermosetting resin material having viscosity of 50 mPa·s or more under measuring condition at 23 °C and 500 Hz, according to the present invention, the resin material does not leak from the mould even when a high pressure is applied to the resin material in a process of forming. Therefore, an optical element having high resin density can be formed to prevent deformation of the optical element by the reflow process.

Since the optical element is formed by using a thermosetting resin material having viscosity of not more than 50,000 mPa·s under measuring condition at 23 °C and 500 Hz, it is possible to prevent that the distortion is dissolved by a reflow process after resin material is cured leaving it contains distortion remained inside. Therefore it is possible to certainly prevent deforming of the optical element by the reflow process. The viscosity of the thermosetting resin material is more preferably not less than 80 mPa·s, and not more than 10,000 mPa·s under measuring condition at 23 °C and 500 Hz.

## BRIEF DESCRIPTION OF DRAWINGS

Fig. 1 is an angled view of an image pick-up device used in a preferable embodiment of this invention.
Fig. 2 is a schematic sectional view of partly expanded image pick-up device used in a preferable embodiment of this invention.
Fig. 3 is drawing to show outline of manufacturing method of an image pick-up device in a preferable embodiment of this invention.
Fig. 4 is a graph showing light transmittance of comparative samples with that of this invention.

## DESCRIPTION OF SYMBOLS

100 Image pick-up device
1 Circuit substrate
2 Camera module
3 Cover case
4 Imaging opening
5 Substrate module

6 Lens module
10 Subsidiary substrate
10a Mounting hole
11 CCD image sensor
12 Sealing resin
15 Lens holder
15a Holder portion
15b Mount portion
16 Lens
17 Collar parts
18 Solder

**MOST PREFERABLE EMBODIMENT TO PRACTICE THE INVENTION**

The preferable embodiments of the present invention are described by referring to drawings.

(1) Image Pick-up Device

The image pick-up device 100 has a circuit board 1 on which electronic parts composing electronic circuit for mobile information terminal such as mobile phone, and a camera module 2 is mounted on the circuit board 1, as illustrated by Fig. 1. The camera module 2 is small one composed of a CCD image sensor and a lens in combination used for board mounting, and can take in image of imaging objective through imaging opening 4 provided in cover case 3 in finished product in which the circuit board mounting electronic parts are incorporated in the cover case 3. Electronic parts other than camera module 2 are not shown in Fig. 1.

The camera module 2 is composed of the substrate module 5 (Fig. 3(a) is referred) and the lens module 6 (Fig. 3(c) is referred) as shown in Fig. 2, and the camera module 2 as a whole is mounted on the circuit substrate 1 by mounting the substrate module 5 on the circuit substrate 1. The substrate module 5 is a photo receiving module comprising subsidiary substrate on which photo receiving element for image formation CCD image sensor 11 is mounted, and an upper surface of CCD image sensor 11 is sealed with resin 12.

Photo receiving part (not illustrated in the drawing) is formed by many photoelectron conversion pixels arranged in lattice form on upper surface of CCD image sensor 11. Charge generated on each pixel by focusing optical image on the photo receiving part is took out as image signal. Subsidiary substrate 10 is mounted on circuit substrate with lead-free solder 18, whereby subsidiary substrate 10 is fixed on the circuit substrate 1, as well as connecting electrodes (not shown) on subsidiary substrate 10 are electrically connected to circuit electrodes (not shown) on the upper surface of circuit substrate 1.

Lens module 6 has lens holder 15 to hold lens 16. Lens 16 is hold by lens holder 16 at upper portion and the upper portion is holder portion 15a to hold lens 16. Bottom portion of lens holder 15 is mounting portion 15b which fixes lens module 6 to subsidiary substrate 10 by inserted into mounting hole 10a provided in subsidiary substrate 10. Lens module is fixed by employing a method of inserting mounting portion 15 into mounting hole 10a with pressure, adhering by adhesives and so on.

(2) Lens

Lens 16 has a function to image light reflected from a subject on the image receiving part of CCD image sensor 11.

(3) Resin Material for Lens

Lens 16 is composed of a specific thermosetting resin material (referred as "resin material" simply hereafter), the resin material has viscosity of 50 to 50,000 mPa·s under measuring condition at 23 °C and 500 Hz, as well as has a coefficient of thermal expansion same as an epoxy type resin disclosed in Patent Document 2 or 3.

Practically, a resin material composing lens 16 contains any one of an allyl ester type resin composition, (poly) ester(meth)acrylate type composition, urethane(meth)acrylate type composition, epoxy(meth)acrylate type composition, an epoxy type resin composition or a silicone type resin composition as a main component.

(3.1) Resin Composition

(3.1.1) Allyl ester Type Resin Composition

Any one of allyl ester type resin compositions (I) to (VI) can be employed as the allyl ester type resin composition.

(3.1.1.1) Allyl ester Type Resin Composition (I)

The allyl ester type resin composition (I) is a composition comprising an ingredient shown below ($\alpha$) as an essential ingredient, and the cured material obtained by curing the composition has a refractive index at 25 °C of not less than 1.58 and specific gravity at 23 °C of not more than 1.40.
Ingredient ($\alpha$): A compound having at least one of groups represented by Formula (1) as a terminal group, and a group represented by Formula (2) as a recurring unit.

Formula (1)

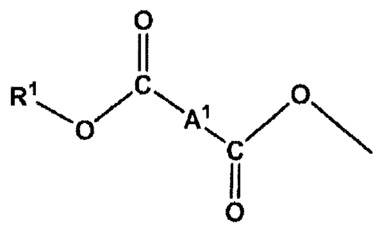

(In the formula, $R^1$ represents, independently any one of an allyl group or a methacryl group, $A^1$ represents, independently 2-valent carboxylic acid or an organic residue group derived from carboxylic acid anhydride.)

Formula (2)

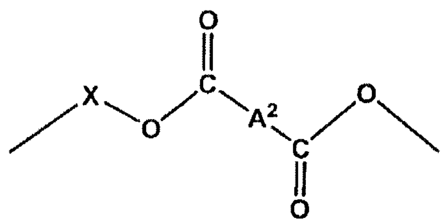

(In the formula, $A^2$ represents, independently 2-valent carboxylic acid or an organic residue group derived from carboxylic acid anhydride, X represents, independently an organic residue group, that is, one or more organic residue groups derived from a bromine atom containing compound having two or more hydroxy groups. X may have a branched structure having above described Formula (1) as a terminal group and above described Formula (2) as a recurring unit by ester bond.

(3.1.1.2) Allyl ester Type Resin Composition (II)

The allyl ester type resin composition (II) is a composition containing ingredient shown below ($\alpha$) of 10 % by weight to 60 % by weight with respect to total curable component, and ingredient shown below ($\beta$) 10 % by weight to 90 % by weight with respect to total curable component, in which the cured material obtained by curing the composition has a refractive index at 25 °C of not less than 1.58 and specific gravity at 23 °C of not more than 1.40.
Ingredient ($\alpha$) A compound having at least one of groups represented by Formula (1) as a terminal group and a group represented by Formula (2) as a recurring unit. Ingredient ($\beta$) A compound having at least one of groups represented by Formula (3) and Formula (4).

Formula (3)

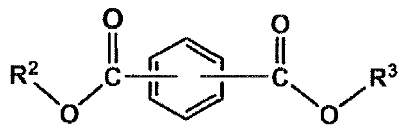

(In the formula, $R^2$ and $R^3$, independently represents any one of an allyl group or a methacryl group.)

Formula (4)

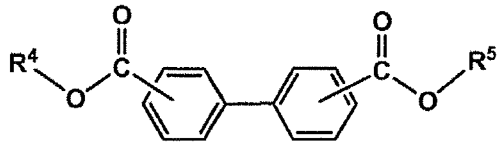

(In the formula, $R^4$ and $R^5$ independently represent any one of an allyl group or a methacryl group.)

(3.1.1.3) Allyl ester Type Resin Composition (III)

The allyl ester type resin composition (III) composition containing ingredient shown below (α) of 10 % by weight to 60 % by weight with respect to total curable component, ingredient (β) of 10 % by weight to 90 % by weight with respect to total curable component, and ingredient (γ) of 0 % by weight to 20 % by weight with respect to total curable component, in which the cured material obtained by curing the composition has a refractive index at 25°C of not less than 1.58 and specific gravity at 23 °C of not more than 1.40.
Ingredient (α) A compound having at least one of groups represented by Formula (1) as a terminal group and a group represented by Formula (2) as a recurring unit.

Formula (1)

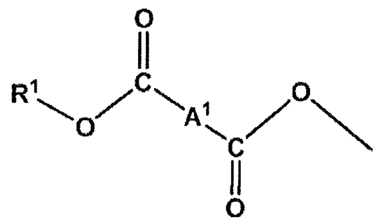

(In the formula, $R^1$ represents, independently any one of an allyl group or a methacryl group, $A^1$ represents, independently 2-valent carboxylic acid or an organic residue group derived from carboxylic acid anhydride.)

Formula (2)

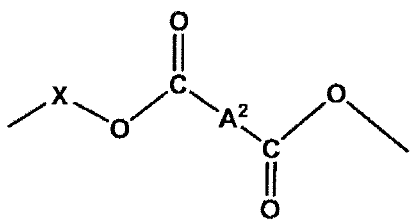

(In the formula, $A^2$ represents, independently 2-valent carboxylic acid or an organic residue group derived from carboxylic acid anhydride, X represents, independently an organic residue group, that is, one or more organic residue

groups derived from a bromine atom containing compound having two or more hydroxy groups. X may have a branched structure having above described Formula (1) as a terminal group and above described Formula (2) as a recurring unit by ester bond.

Ingredient (β) A compound having at least one of groups represented by Formula (3) and Formula (4).

Formula (3)

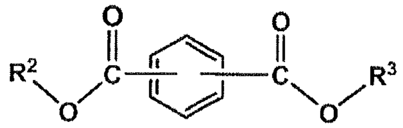

(In the formula, $R^2$ and $R^3$ independently represent any one of an allyl group or a methacryl group.)

Formula (4)

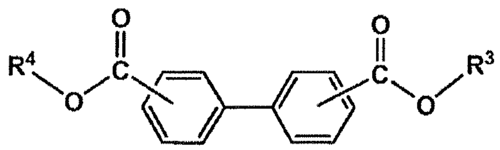

(In the formula, $R^4$ and $R^5$ independently represent any one of an allyl group or a methacryl group.)

Ingredient (γ) at least one compound selected from the group consisting of dibenzyl maleate, diphenyl maleate, dibenzyl fumarate, diphenyl fumarate, 2-phenylbenzoic acid(meth)allyl, 3-phenylbenzoic acid(meth)allyl, 4-phenylbenzoic acid (meth)allyl, α-naphthoic acid(meth)allyl, β-naphthoic acid(meth)allyl, o-chrolobenzoic acid(meth)allyl, m-chrolobenzoic acid(meth)allyl, p-chrolobenzoic acid(meth)allyl, 2,6-dichlorobenzoic acid(meth)allyl, 2,4-dichlorobenzoic acid(meth) allyl, o-bromobenzoic acid(meth)allyl, m-bromobenzoic acid(meth)allyl and p-bromobenzoic acid(meth)allyl.

The term of total curable component described in this specification is a total amount of polymerizable component contained in any one of allyl ester type resin compositions (I) to (III).

In Formula (1) $R^1$ independently represents any one of an allyl group or a methacryl group, and in Formula (1) $A^1$ independently represents 2-valent carboxylic acid or an organic residue group derived from carboxylic acid anhydride. In Formula (2), $A^2$ independently represent 2-valent carboxylic acid or an organic residue group derived from carboxylic acid anhydride. In Formula (2), X represents, independently an organic residue group, that is, one or more organic residue groups derived from a bromine atom containing compound having two or more hydroxy groups.

The term of "$R^1$ independently represents" means that as for $R^1$ in a terminal group represented by Formula (1), which is essential ingredient of the allyl ester type resin composition (I) to (III), all of $R^1$ may be an acryl group or a methacryl group or a part of $R^1$ may be an acryl group and another part may be a methacryl group. These are not restricted to the practical examples.

$A^1$ in formula (1) and $A^2$ in Formula (2) represent respectively 2-valent carboxylic acid or an organic residue group derived from carboxylic acid anhydride. Examples of the "2-valent carboxylic acid or an organic residue group derive from carboxylic acid anhydride" include the following compounds. It is not restricted to these examples.

Aliphatic dicarboxylic acid or its anhydride such as succinic acid or its anhydride, glutaric acid or its anhydride, adipic acid, malonic acid or its anhydride, and 2-methylsuccinic acid or its anhydride; dicarboxylic acid having alicyclic structure or its anhydride such as 1,4-cyclohexane dicarboxylic acid, 1,3-cyclohexane dicarboxylic acid, 1,2-cyclohexane dicarboxylic acid or its anhydride, and 4-methylcyclohexane-1,2-dicarboxylic acid or its anhydride; and aromatic dicarboxylic acid or its anhydride such as terephthalic acid, isophthalic acid, phthalic acid or its anhydride, biphenyl-2,2'-dicarboxylic acid (referred also as diphen acid, hereafter) or its anhydride, biphenyl-3,3'-dicarboxylic acid, biphenyl-4,4'-dicarboxylic acid.

Preferable example is, particularly, aromatic dicarboxylic acid or its anhydride such as terephthalic acid, isophthalic acid, phthalic acid or its anhydride, biphenyl-2,2'-dicarboxylic acid or its anhydride, biphenyl-3,3'-dicarboxylic acid and biphenyl-4,4'-dicarboxylic acid from a view point of maintaining high refractive index of the compound, among those described above, and more preferably, isophthalic acid, and biphenyl-2,2'-dicarboxylic acid or its anhydride.

The term "$A^1$ independently represents" or "$A^2$ independently represents" means that as for $A^1$ in a terminal

group represented by Formula (1) in Ingredient (α) which is essential ingredient of the allyl ester type resin composition (I) to (III), and $A^2$ in a terminal group represented by Formula (1) in Ingredient (α) which is essential ingredient of the allyl ester type resin composition (I) to (III), ("$A^1$" and "$A^2$" are referred as "A" including both, hereafter), all of A are 2-valent carboxylic acid or an organic residue group derived from carboxylic acid anhydride having the same structures, all of A are 2-valent carboxylic acid or an organic residue group derived from carboxylic acid anhydride having different structures, or a part of A are 2-valent carboxylic acid or an organic residue group derived from carboxylic acid anhydride having the same structures and the other are 2-valent carboxylic acid or an organic residue group derived from carboxylic acid anhydride having different structure.

In Structural Formula (16) described below, an example of Ingredient (α) which is essential ingredient of an allyl ester type resin composition (I) to (III), each of k pieces A's are independent.

Structural Formula (16)

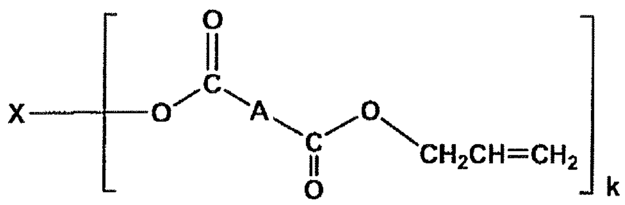

(In Structural Formula (16), A independently represents an organic residue group derive from 2-valent carboxylic acid, K is an integer of 2 or more. X is an organic residue group derived from a bromine atom containing compound having two or more hydroxy groups.)

For example, k pieces A's in Structural Formula (16) may be 2-valent carboxylic acid or an organic residue group derive from its anhydride having different structure each other, (that is, each is 2-valent carboxylic acid or an organic residue group derive from its anhydride having k pieces structure respectively), 2-valent carboxylic acid or an organic residue group derive from its anhydride all having the same structure (namely, having k pieces common structure 2-valent carboxylic acid or an organic residue group derive from its anhydride), or mixture structure of comprising partly 2-valent carboxylic acid or an organic residue group derive from its anhydride having the same structure and 2-valent carboxylic acid or an organic residue group derive from its anhydride having other structures.

The term "X is independently an organic residue group" means that each of m pieces X's is independent organic residue group in Structural Formula (17) which is an example of a recurring unit represented by Formula (2).

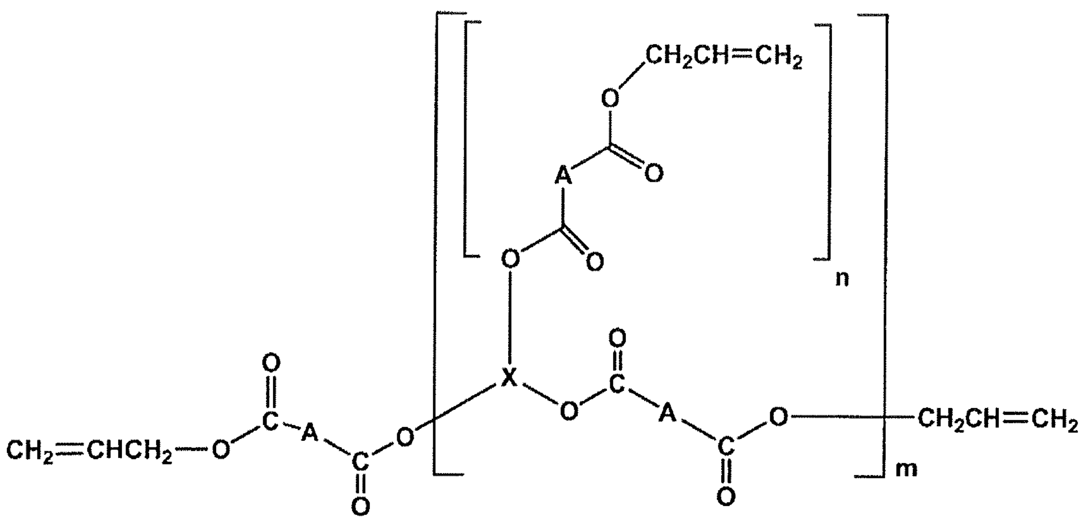

Structural Formula (17)

(In Structural Formula (17), X represents, independently an organic residue group, that is, one or more organic residue groups derived from a bromine atom containing compound having two or more hydroxy groups, m is an integer of 0, 1 or more. n is an integer of 0, 1 or more, A independently represents 2-valent carboxylic acid or an organic residue group derive from its anhydride.)

For example, each of m pieces X's in Structural Formula (17) may be different organic residue group derived from bromine containing compound, (namely, m pieces of organic residue group derived from a bromine atom containing compound in each), all may be an organic residue group derived from a bromine atom containing compound, (namely, having m pieces of one kind of organic residue group derived from a bromine atom containing compound), or some of them are a kind of organic residue group derived from a bromine atom containing compound and the other are another kind of organic residue group derived from a bromine atom containing compound in mixture, among m pieces of X. Further the mixed structure may be that all are completely random or partly recurring.

The term of "one or more organic residue groups comprising an organic residue group derived from a bromine atom containing compound as an essential ingredient" means that all or a part of m pieces X's, contained in the recurring structure of Structural Formula (17) which is an example of recurring unit represented by Formula (2), contains an organic residue group derived from a bromine atom containing compound.

For example, all of m pieces X's in the in Structural Formula (17) may be an organic residue group derived from a bromine atom containing compound, (namely, m pieces of an organic residue group derived from at least one kind of a bromine atom containing compound), some of X is an organic residue group derived from a bromine atom containing compound and the other is an organic residue group derived from the other kinds of compound, among m pieces of X's. Further, the mixed structure may be all are completely random or partly recurring.

Further, X may have a branched structure comprising terminal group of Formula (1) and a recurring unit of Formula (2) by ester bond. That is, Ingredient ($\alpha$) which is essential ingredient of an allyl ester type resin composition (I) to (III), may have a partial structure represented by Structural Formula (18) shown below, when X comprises an organic residue group derived from 2,4,6-tribramo-1,3,5-tri(hydroxyethyl) benzene, which is an example of 3-valent bromine atom containing alcohol.

Structural Formula (18)

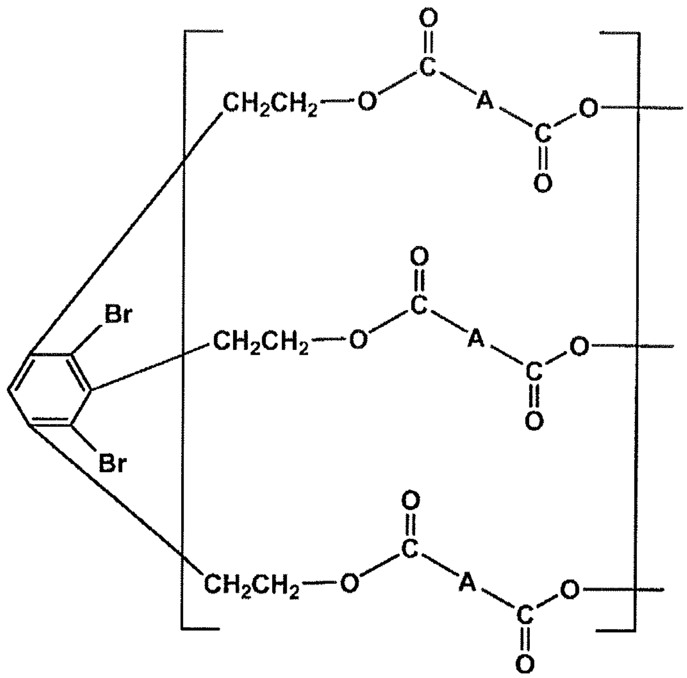

X is, independently an organic residue group which is one or more organic residue groups comprising an organic residue group derived from a bromine atom containing compound as an essential ingredient. A independently represents 2-valent carboxylic acid or an organic residue group derive from its anhydride.

X in Formula (2) is, independently an organic residue group, which is one or more organic residue groups comprising an organic residue group derived from a bromine atom containing compound as an essential ingredient. Here, "a bromine atom containing compound having two or more hydroxy groups" includes those shown below. It is not limited thereto.

Structural Formula (19)

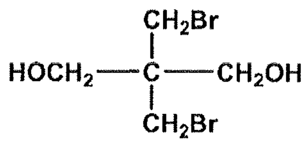

Further, a bromine atom containing compound having two or more hydroxy groups shown below Formulae (5) or Formula (6) may be employed.

Formula (5)

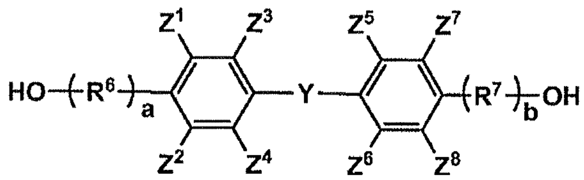

(In the formula, $R^6$ independently represents at least one organic group selected from those represented by Structural Formulae (1) to (3) shown below, $R^7$ independently represents at least one selected from Structural Formula (4) to (6) shown below. In the formula, a and b independently represents an integer of 0 or 1 to 10, $Z^1$, $Z^2$, $Z^3$, $Z^4$, $Z^5$, $Z^6$, $Z^7$ and $Z^8$ independently represents at least one kind of substituent selected from bromine atom, chlorine atom and hydrogen atom, and at least one of $Z^1$, $Z^2$, $Z^3$, $Z^4$, $Z^5$, $Z^6$, $Z^7$ and $Z^8$ is bromine atom. In the formula, Y represents any one of an organic group selected from Structural Formula (7) or Structural Formula (8) shown below.)

Formula (6)

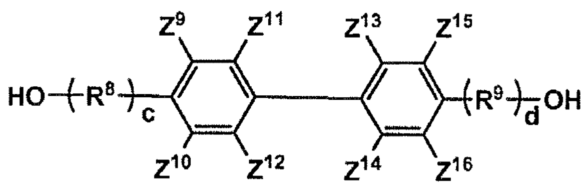

(In the formula, $R^8$ independently represents at least one organic group selected from Structural Formula (9) to Structural Formula (11) shown below, $R^9$ independently represents at least one selected from Structural Formula (12) to Structural Formula (14) shown below. In the formula, c and d independently represent an integer of 0 or 1 to 10, $Z^9$, $Z^{10}$, $Z^{11}$, $Z^{12}$, $Z^{13}$, $Z^{14}$, $Z^{15}$ and $Z^{16}$ independently represent at least one kind of a substituent selected from bromine atom, chlorine atom and hydrogen atom, and at least one of $Z^9$, $Z^{10}$, $Z^{11}$, $Z^{12}$, $Z^{13}$, $Z^{14}$, $Z^{15}$ and $Z^{16}$ is bromine atom.)

Structural Formula (1) $-CH_2CH_2O-$

Structural Formula (2)

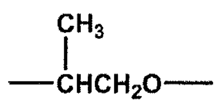

Structural Formula (3)

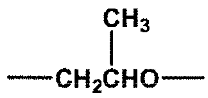

Structural Formula (4) $-OCH_2CH_2-$

Structural Formula (5)

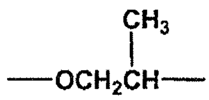

Structural Formula (6)

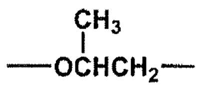

Structural Formula (7) $-CH_2-$

Structural Formula (8)

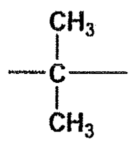

Structural Formula (9) $-CH_2CH_2O-$

Structural Formula (10)

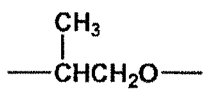

Structural Formula (11)

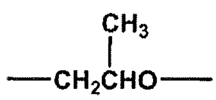

Structural Formula (12) $-OCH_2CH_2-$

Structural Formula (13)

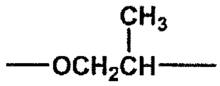

Structural Formula (14)

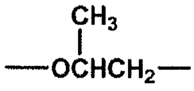

In Formula (5) "$R^6$ independently represents" means that all of a pieces of $R^6$ has an organic group of same structure, or all are an organic group having different structure each other, or, an organic group partly having same structure and different structure in the other parts. $R^6$ should be selected from organic groups represented by Structural Formulae (1) to (3).

In Formula (5) "$R^7$ independently represents" means that all of b pieces of $R^7$ has an organic group of same structure, or all are an organic group having different structure each other, or, an organic group partly having same structure and different structure in the other parts. $R^7$ should be selected from organic groups represented by Structural Formulae (4) to (6).

Further, in Formula (5) a and b independently represents an integer of 0 or 1 to 10.

Y represents an organic group selected from Structural Formula (7) and (8).

Practical examples of a bromine atom containing compound having two or more hydroxy groups represented by Formula (5) include 2,2-bis[4-(2-hydroxyethoxy)-3,5-dibromophenyl]propane, 2,2-bis[4-(2-hydroxypropoxy)-3,5-dibromophenyl]propane, 3 mol ethyleneoxide adduct of 2,2-bis(3,5-dibromo-4-hydroxyphenyl) propane, 4 mol propyleneoxide adduct of 2,2-bis(3,5-dibromo-4-hydroxyphenyl) propane, 2,2-bis[4-(2-hydroxyethoxy)-3,5-dibramophenyl]methane, 2,2-bis[4-(2-hydroxypropoxy)-3,5-dibromophenyl]methane, 3 mol-ethyleneoxide adduct of 2,2-bis(3,5-dibromo-4-hydroxyphenyl)methane and 4 mol propyleneoxide adduct of 2,2-bis(3,5-dibromo-4-hydroxyphenyl)methane. It is not restricted thereto.

Among the bromine atom containing compound described above, 2,2-bis[4-(2-hydroxyethoxy)-3,5-dibromophenyl]propane, 2,2-bis[4-(2-hydroxypropoxy)-3,5-dibromophenyl]propane are used preferably in view of easy availability, and more preferably, 2,2-bis[4-(2-hydroxyethoxy)-3,5-dibromophenyl]propane.

In Formula (6) "$R^8$ independently represents" means that all of c pieces of $R^8$ may have an organic group of same structure, or all may be an organic group having different structure each other, or, an organic group partly having same structure and different structure in the other parts. $R^8$ should be an organic group selected from Structural Formulae (9) to (11).

In Formula (6) "$R^9$ independently represents" means that all of d pieces of $R^9$ has an organic group of same structure, or all are an organic group having different structure each other, or, an organic group partly having same structure and different structure in the other parts. $R^9$ should be an organic group selected from Structural Formulae (12) to (14).

Further in Formula (6) c and d independently represents an integer of 0 or 1 to 10.

Practical examples of bromine atom containing compound having two or more hydroxy groups represented by Formula (6) include 4,4'-bis(2-hydroxyethoxy)-3,3' ,5,5' tetrabromodiphenyl, ethyleneoxide 3 mol adduct of 4,4'-bis(2-hydroxypropoxy)-3,3',5,5'-tetrabromodiphenyl, 4,4'-dihydroxy-3,3',5,5'-tetrabromodiphenyl, and propyleneoxide 3 mol adduct of 4,4'-dihydroxy-3,3',5,5'-tetrabromodiphenyl. It is not restricted to these practical examples.

In the bromine atom containing compound above described 4,4'-bis(2-hydroxyethoxy)-3,3',5,5'-tetrabromodiphenyl,4,4'-bis(2-hydroxypropaxy)-3,3',5,5'-tetrabromodiphenyl are used preferably, and 4,4'-bis(2-hydroxyeth.oxy)-3,3',5,5'-tetrabromodiphenyl are particularly preferable.

The other alcohols can be employed in addition to the bromine atom containing compound having two or more hydroxy groups in combination. The practical examples include the following compound. It is not restricted to these practical examples.

Examples include 1,4-di(hydroxymethyl) benzene, 1,3-di(hydroxymethyl) benzene, 1,2-di(hydroxymethyl) benzene, bis[4-(2-hydroxyethoxy)phenyl] methane, 1,1-bits[4-(2-hydroxyethoxy)phenyl] cyclohexane, 2,2-bis[4-(2-hydroxyethoxy)phenyl] propane, bis[4-(2-hydroxypropoxy)phenyl] methane, 1,1-bis[4-(2-hydroxypropoxy)phenyl] cyclohexane, 2,2-bis[4-(2-hydroxypropoxy)phenyl] propane, bisphenol A ethyleneoxide 3 mol-adduct, bisphenol F ethyleneoxide 4 mol adduct, bisphenol Z, ethyleneoxide 3 mol-adduct, 1,4-bis(2-hydroxyethoxy) benzene, 1,3-bis(2-hydroxyethoxy) benzene, 1,2-bis(2-hydroxyethoxy) benzene, 4,4'-bis(2-hydroxyethoxy) diphenyl, 3,3'-bis(2-hydroxyethoxy) diphenyl and 2,2'-bis(2-hydroxyethoxy) diphenyl.

The number of recurring units of the group represented by Formula (2), which is a recurring unit of Ingredient ($\alpha$), which is an essential ingredient of the allyl ester type resin composition (I) to (III), is not particularly limited. Various materials having the number of recurring units may be used in mixture. Mixture of a compound having the number of recurring units of 0 (namely, a compound represented by Formula (8) shown below) and compound having the number of recurring units of an integer of 1 or more may be used in combination. In this instance, the number of recurring units is preferably 1 or more.

The Ingredient ($\alpha$), which is an essential ingredient of the allyl ester type resin composition (I) to (III) is defined that a residual compound represented by Formula (8)shown below be not included in this specification.

Namely, in case that diallyl isophthalate remains when diallyl isophthalate is used as a raw material for preparing Ingredient ($\alpha$), the remaining diallyl isophthalate is not included in Ingredient ($\alpha$), but is included in Ingredient ($\beta$) which is an essential ingredient of the allyl ester type resin composition (II) and (III).

Further, in case that diallyl succinate remains when diallyl succinate is used as a raw material for preparing Ingredient ($\alpha$), the remaining diallyl succinate is neither included in Ingredient ($\alpha$) nor Ingredient ($\beta$).

Formula (8)

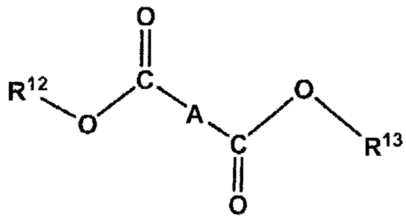

(In the formula, A is 2-valent carboxylic acid or an organic residue group derived from carboxylic acid anhydride, $R^{12}$ and $R^{13}$ independently represents any one of an allyl group or a methacryl group.) In Formula (8) A represents 2-valent carboxylic acid or an organic residue group derived from carboxylic acid anhydride. Examples of 2-valent carboxylic acid or carboxylic acid anhydride include a compound shown below. It is not restricted to these practical examples.

An aliphatic dicarboxylic acid or its anhydride, such as succinic acid or its anhydride, glutaric acid or its anhydride, adipic acid, malonic acid or its anhydride, and 2-methylsuccinic acid or its anhydride; a dicarboxylic acid having an alicyclic structure or its anhydride such as 1,4-cyclohexane dicarboxylic acid, 1,3-cyclohexane dicarboxylic acid, 1,2-cyclohexane dicarboxylic acid or its anhydride, and 4-methylcyclohexane-1,2-dicarboxylic acid or its anhydride; and an aromatic dicarboxylic acid or its anhydride such as terephthalic acid, isophthalic acid, phthalic acid or its anhydride, biphenyl-2,2'-dicarboxylic acid or its anhydride, biphenyl-3,3'-dicarboxylic acid and biphenyl-4,4'-dicarboxylic acid.

Among the above described compounds, the aromatic dicarboxylic acid or its anhydride such as terephthalic acid, isophthalic acid, phthalic acid or their anhydride, biphenyl-2,2'-dicarboxylic acid or its anhydride, biphenyl-3,3'-dicarboxylic acid and biphenyl-4,4'-dicarboxylic acid are particularly preferable, and more preferably, isophthalic acid, biphenyl-2,2'-dicarboxylic acid or their anhydride, from a view point of maintaining high refractive index of a component.

It is usually preferable that the number of recurring units of a group represented by Formula (2), which is a recurring unit of Ingredient ($\alpha$), which is an essential ingredient of the allyl ester type resin composition (I) to (III) is an integer of 1 to 30. It is not preferable from view points that curing delay is apt to occur in curing process, there is a possibility of affecting deterioration in physical propertied such as mechanical strength of cured material due to remaining uncured state, and further there is a possibility of causing extreme increase of viscosity, when Ingredient ($\alpha$) composed of only a compound having the number of recurring units exceeding 30 is used in a composition for plastic lens, concentration of the allyl group is low. It is preferable that the number of recurring units in all compounds of Ingredient ($\alpha$) is an integer of 1 to 30, more preferably an integer of 1 to 20, and furthers preferably an integer of 1 to 10.

In a preparation process of Ingredient ($\alpha$), which is an essential ingredient of the allyl ester type resin composition (I) to (III), the compound represented by Formula (8) as its raw material, may remain depending on preparation condition, there is no problem to employ for a plastic lens composition without removing the compound represented by Formula (8) as remained. However, it is not preferable that the compound represented by Formula (8) is in excess of 90 % by weight with respect to total curable component in case that it is used in an allyl ester type resin composition (I) to (III) since content of bromine atom is too little, causing refractive index of the cured material too little.

A content of formulation of Ingredient ($\alpha$) in the allyl ester type resin composition is preferably 10 % by weight to 60 % by weight with respect to total curable component, more preferably, 15 % by weight to 50 % by weight, and particularly preferably, 20 % by weight to 45 % by weight.

It is not preferable that the content of formulation of Ingredient (α) in an allyl ester type resin composition is not more than 10 % by weight with respect to total curable component, since it is difficult to maintain a refractive index of not less than 1.58 and to maintain Abbe number of not less than 30, of the cured material obtained by curing composition for plastic lens. It is not preferable that the content of formulation of Ingredient (α) in an allyl ester type resin composition exceeds 60 % by weight with respect to total curable component, since viscosity of composition is extremely high and there is a possibility that specific gravity of cured material exceeds 1.40.

It is preferable that Ingredient (β) is used in the allyl ester type resin composition to control viscosity of the composition and to maintain refractive index of cured material of not less than 1.58.

Formula (3)

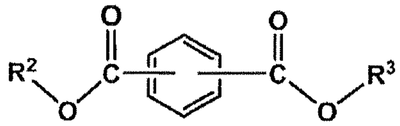

(In the formula, $R^2$ and $R^3$ independently represent any one of an allyl group or a methacryl group.)

Formula (4)

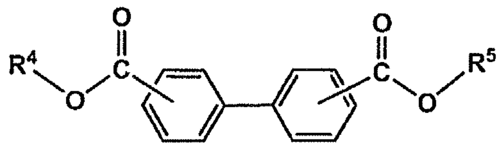

(In the formula, $R^4$ and $R^5$ independently represent any one of an allyl group or a methacryl group.)

Content of formulation of the represented by compound Formula (3) and Formula (4), which varies depending on kinds of compound as use, is, to 90 % by weight with respect to total curable component, more preferably, 40 % by weight to 80 % by weight, and particularly preferably, 50 % by weight to 80 % by weight. It is not preferable that content of formulation of the represented by compound Formula (3) and Formula (4) is not less than 10 % by weight with respect to total curable component, since viscosity of the composition is extremely high. It is not preferable that content of formulation of the represented by compound Formula (3) and Formula (4) exceeds 90 % by weight, since it is difficult to maintain a refractive index of not less than 1.58 and to maintain Abbe number of not less than 30, of the cured material obtained by curing composition for plastic lens.

"Abbe number" described in this specification is a value representing degree of dispersion of optical glass, and is described in the item of "Abbe number" of Butsurigaku Jiten (Dictionary of Physics), small size edition, edited by Butsurigaku Jiten Henshu Iinkai, first edition, published on November 30, 1989, by Baifukan, in detail.

Abbe number described in this specification is measured by "Abbe's refractometer 1T" manufactured by Atago Co., Ltd., and represented by the formula below.

$$\text{Abbe number } (\nu_D) = (n_D - 1)/(n_F - n_C)$$

(In the formula, $n_D$, $n_F$ and $n_C$ each is refractive index corresponding to Fraunhofer's d line (wave length of 578.6 nm), F line (486.1 nm) and C line (656.3 nm) at 25 °C.)

The Ingredient (α), which is an essential ingredient of the allyl ester type resin composition (I) to (III) can be prepared by, for example, the following method.

The target compound can be obtained by a process in which at least one of a compound represented by Formula (5) in predetermined ratio is used, and these compounds and at least one of bromine atom containing compound composing at least one of bromine atom containing compound having two or more hydroxy groups as an essential ingredient are subjected to ester exchange reaction in the presence of a catalyser. The method is not limited to this. A purifying process may be included.

A catalyser employed in the process described above is not particularly limited if it is used in general ester exchange reaction. An organic metal compound is particularly preferable and practical example includes, practically,

tetraisopropoxy titanium, tetrabutoxy titanium, dibutyl tin oxide, dioctyl tin oxide, hafnium acetylacetonate and zirconium acetylacetonate, but is not limited to these. Dibutyl tin oxide and dioctyl tin oxide are preferable among them.

Reaction temperature in this process is not particularly limited, and preferably 100 °C to 230 °C, and more preferably 120 °C to 200°C. It may be restricted by boiling point of a solvent particularly when solvent is used.

Though solvent is not usually used in this process, it is possible to use solvent, if necessary. Solvent able to be used is not particularly limited if ester exchange reaction is not inhibited. Practical example benzene includes toluene, xylene and cyclohexane, but is not limitative. Benzene and toluene is preferable among these. However, it is possible to conduct without employing solvent as described above.

to obtain Ingredient (α), which is an essential ingredient of the allyl ester type resin composition (I) to (III), It is necessary that total number of carboxylate groups in the compound represented by Formula (8) be more than total number of hydroxy groups of one or more kinds of bromine atom containing compound having two or more hydroxy groups as an essential ingredient.

When ratio of total number of carboxylate groups of the Compound represented by Formula (8) described above to total number of hydroxy groups in above the bromine atom containing compound described is too closed to 1/1, number average molecular weight of formed Ingredient (α) is extremely too large, and it is not available to use as an allyl ester type resin composition (I) to (III). ratio of total number of carboxylate groups of the Compound represented by Formula (8) described above to total number of hydroxy groups in above the bromine atom containing compound described is preferably 4/3 to 10/1, more preferably 3/2 to 8/1, and further preferably 2/1 to 7/1.

On the other hand, a compound polymerizable with Ingredient (α) or Ingredient (β) may be incorporated in an allyl ester type resin composition (I) and (II), mainly for a purpose viscosity control of the composition in an amount not exceeding 20 % by weight with respect to total curable component contained in the allyl ester type resin composition (I) and (II), and preferable.

Example of the compound includes a monomer having (meth)acryl group, a vinyl group or (meth)allyl group. Practical examples include methyl(meth)acrylate, isobornyl(meth)acrylate, vinyl acetate, vinyl benzoate, diphenyl maleate, dibenzyl maleate, dibutyl maleate, dimethoxyethyl maleate, diphenyl fumarate, dibenzyl fumarate, dibutyl fumarate and dimethoxyethyl fumarate.

The term of (meth)acryl described in this specification means acryl and methacryl. Further, (meth)acrylate described in this specification means acrylate and methacrylate.

A monomer having a (meth)allyl group include α-naphthoic acid(meth)allyl, β-naphthoic acid(meth)allyl, 2-phenylbenzoic acid(meth)allyl, 3-phenylbenzoic acid(meth)allyl, 4-phenylbenzoic acid(meth)allyl, benzoic acid(meth) allyl, o-chrolobenzoic acid(meth)allyl, m-chrolobenzoic acid(meth)allyl, p-chrolobenzoic acid(meth)allyl, 2,6-dichlorobenzoic acid(meth)allyl, 2,4-dichlorobenzoic acid(meth)allyl, 2,4,6-trichralobenzoic acid(meth)allyl, o-bromobenzoic acid (meth)allyl, m-bromobenzoic acid(meth)allyl, p-bromobenzoic acid(meth)allyl, 2,6-dibromobenzoic acid(meth)allyl, 2,4-dibromobenzoic acid(meth)allyl, 2,4,6-tribromobenzoic acid(meth)allyl, 1,4-cyclohexane dicarboxylic acid di(meth)allyl, 1,3-cyclohexane dicarboxylic acid di(meth)allyl, 1,2-cyclohexane dicarboxylic acid di(meth)allyl, 4-cyclohexene-1,2-dicarboxylic acid di(meth)allyl, 1-cyclohexene-1,2-dicarboxylic acid di(meth)allyl, 3-methyl-1,2-cyclohexane dicarboxylic acid di(meth)allyl, 4-methyl-1,2-cyclohexane dicarboxylic acid di(meth)allyl, Endic acid di(meth)allyl, Chlorendic acid di (meth)allyl and 3,6-methylene-1,2-cyclohexane dicarboxylic acid di(meth)allyl. Further, it includes polyethyleneglycol bis((meth)allylcarbonate) resin, represented by trade name of CR-39 manufactured by PPG Industries, Inc. It is not limited to these, and, it is possible to use the other monomers and so on in addition to these practical examples as far as property of material of the plastic lens is not defected.

Preferable examples of the compound polymerizable with Ingredient (α) or Ingredient (β) as described above, considering a balance of realizing low specific gravity and maintaining high refractive index of the cured material, dibenzyl maleate, diphenyl maleate, dibenzyl fumarate, diphenyl fumarate, 2-phenylbenzoic acid(meth)allyl, 3-phenylbenzoic acid(meth)allyl, 4-phenylbenzoic acid(meth)allyl, α-naphthoic acid(meth)allyl, β-naphthoic acid(meth)allyl, o-chrolobenzoic acid(meth)allyl, m-chrolobenzoic acid(meth)allyl, p-chrolobenzoic acid(meth)allyl, 2,6-dichlorobenzoic acid(meth) allyl, 2,4-dichlorobenzoic acid(meth)allyl, o-bromobenzoic acid(meth)allyl, m-bromobenzoic acid(meth)allyl and p-bromobenzoic acid(meth)allyl, and particularly preferably, dibenzyl maleate, diphenyl maleate, dibenzyl fumarate, diphenyl maleate, 2-phenylbenzoic acid(meth)allyl, 3-phenylbenzoic acid(meth)allyl, 4-phenylbenzoic acid(meth)allyl, α-naphthoic acid(meth)allyl and β-naphthoic acid(meth)allyl are mentioned.

The term of (meth)allyl described in this specification means allyl and methallyl.

The refractive index ($n_D$) of the cured material obtained by curing the composition of an allyl ester type resin composition (I) to (III) at 25 °C should be not less than 1.58, and preferably, 1.585 or more. In case that refractive index ($n_D$) of the cured material at 25 °C is not more than 1.58, targeted high refractive index lens can not be obtained.

The term of "refractive index" described in this specification is a ratio of the velocity of light in vacuum c to phase velocity in a medium υ, c/υ, and is detailed in the item of "refractive index" of Butsurigaku Jiten (Dictionary of Physics), small size edition, edited by Butsurigaku Jiten Henshu Iinkai, first edition, published on November 30, 1989, by Baifukan.

Further, value of refractive index described in this specification is refractive index corresponding to Fraunhofer's d line (wave length of 587.6 nm), measured by employing "Abbe's refractometer 1T" manufactured by Atago Co., Ltd. at 25 °C. The principle of measuring refractive index of "Abbe's refractometer 1T" manufactured by Atago Co., Ltd. is a method to measure critical angle of total reflection, and, is described in "(1) a method measuring critical angle of total reflection" part in the item of "refractometer" of Butsurigaku Jiten (Dictionary of Physics), small size edition, edited by Butsurigaku Jiten Henshu Iinkai, first edition, published on November 30, 1989, by Baifukan, in detail.

The specific gravity of the cured material obtained by curing composition of an allyl ester type resin composition (I) to (III) at 23°C should be not more than 1.40. It is preferably not more than 1.39. The specific gravity the cured material obtained by curing the composition at 23 °C is larger than 1.40, the targeted light weight plastic lens can not be obtained.

The "specific gravity" described in this specification is a ratio of mass of a material to mass of standard material having the same volume (water at 4 °C, and standard atmosphere), is described in the item of "specific gravity" of Butsurigaku Jiten (Dictionary of Physics), small size edition, edited by Butsurigaku Jiten Henshu Iinkai, first edition, published on November 30, 1989, by Baifukan, in detail.

The value of specific gravity of cured material described in this specification is measured by sink-float method (measuring temperature 23 °C) according to JIS K7112.

(3.1.1.4) Allyl Ester Type Resin Composition (IV)

The allyl ester type resin composition (IV) is any one of an allyl ester type resin composition (I) to (III) containing a ultraviolet absorbing agent and/or a light stabilizer in an amount of 0.01 parts by weight to 2 parts by weight with respect to 100 parts by weight of the total curable component.

An ultraviolet absorbing agent or a light stabilizer is used in the allyl ester type resin composition (IV) to improve resistance to weather performance. The ultraviolet absorbing agent or the light stabilizer is not particularly limited, as far as it is incorporated in the composition, practically, compounds shown below are included. It is not restricted to these practical examples.

The term "ultraviolet absorbing agent" described in this specification means a material absorbing light energy such as sun light and fluorescent tube light and converting to heat energy etc. The "light stabilizer" described in this specification is a material capturing a radical generated by deterioration due to photo-oxidation.

practical examples of the ultraviolet absorbing agent include compounds having benztriazole structural unit represented by Structural Formula (15) shown below.

Structural Formula (15)

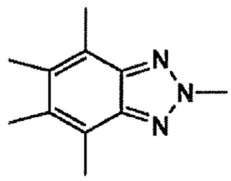

Practical examples of the compound having a structural unit above described include compounds shown by Structural Formula (20) to (35) shown below.

Structural Formula (20)

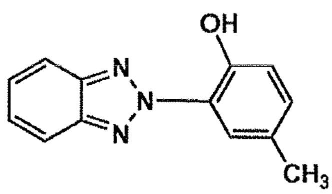

Structural Formula (21)

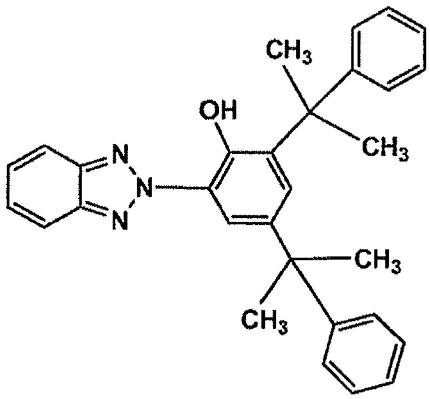

Structural Formula (22)

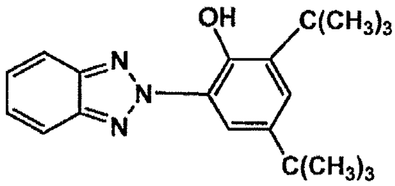

Structural Formula (23)

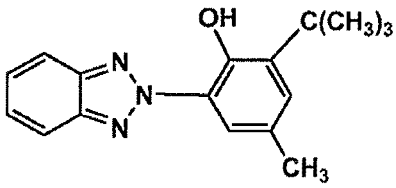

Structural Formula (24)

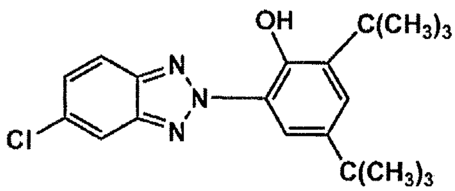

Structural Formula (25)

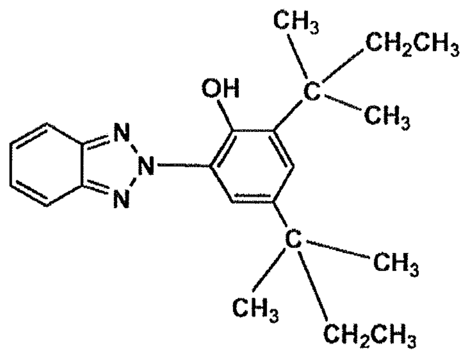

Structural Formula (26)

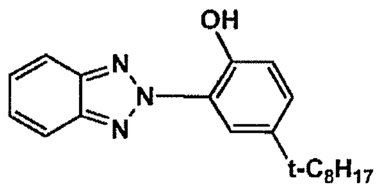

Structural Formula (27)

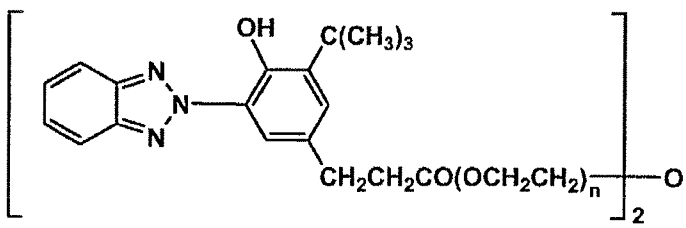

Structural Formula (28)

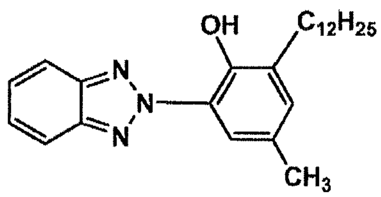

Structural Formula (29)

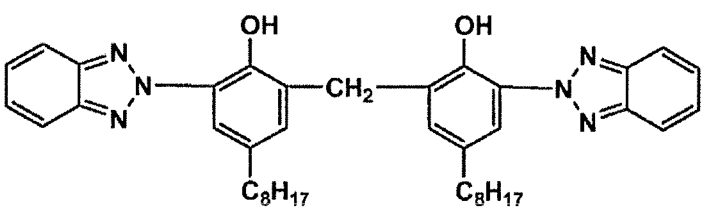

Structural Formula (30)

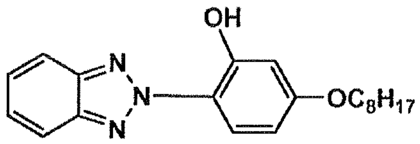

Structural Formula (31)

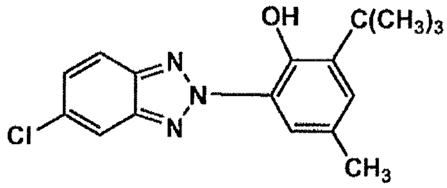

Structural Formula (32)

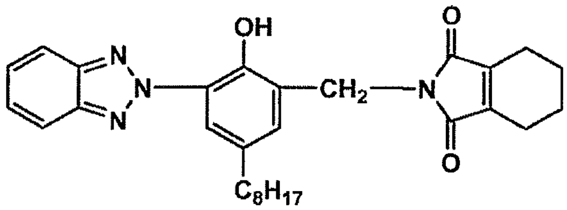

Structural Formula (33)

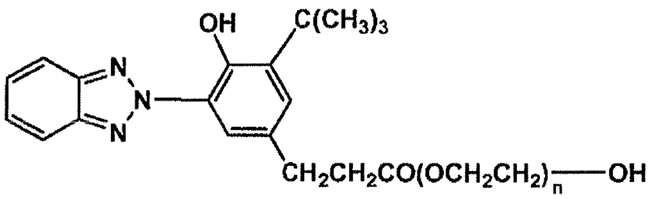

Structural Formula (34)

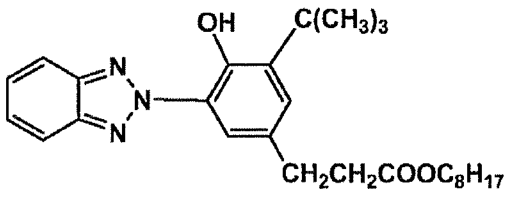

Structural Formula (35)

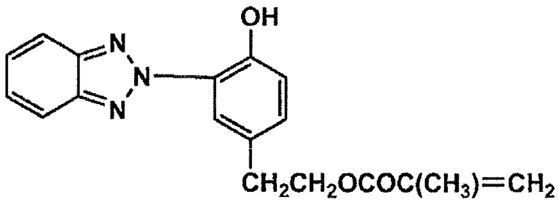

Practical examples of the benzophenone type ultraviolet absorbing agent include compounds of Structural Formula (36) to (40) shown below.

Structural Formula (36)

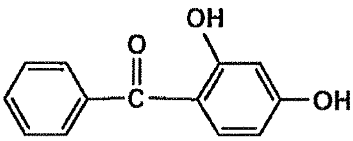

Structural Formula (37)

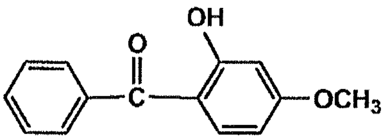

Structural Formula (38)

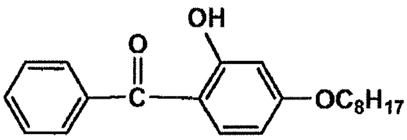

Structural Formula (39)

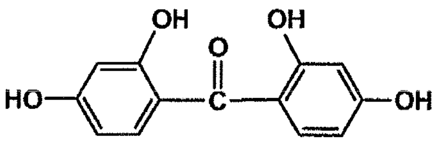

Structural Formula (40)

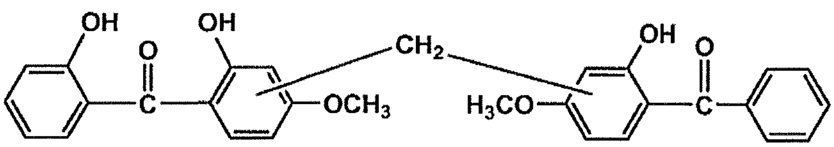

Further, an ultraviolet absorbing agent of Structural Formula (41) shown below and an oxalic acid anilide type

ultraviolet absorbing agent of Structural Formula (42) shown below may be used.

Structural Formula (41)

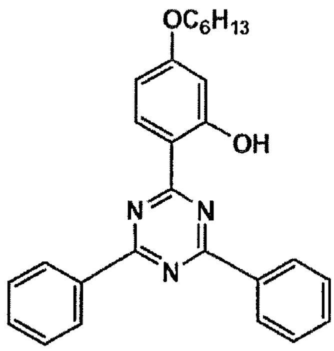

Structural Formula (42)

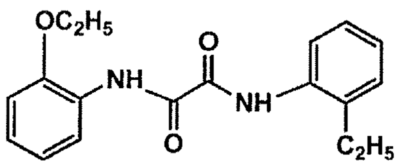

Practical examples of light stabilizer include a hindered amine type light stabilizer (abbreviated as "HALS" hereafter) of Structural Formulae (43) to (50), (52) and (54) to (57) shown below.

Structural Formula (43)

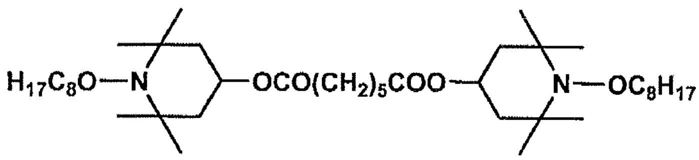

Structural Formula (44)

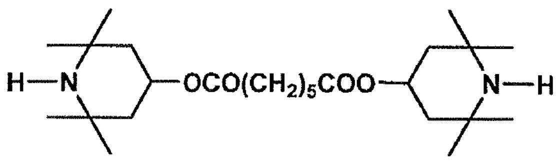

Structural Formula (45)

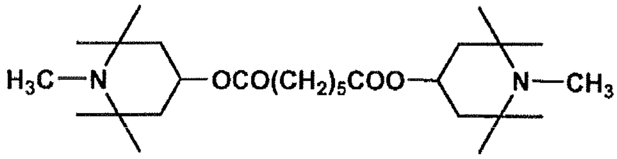

Structural Formula (46)

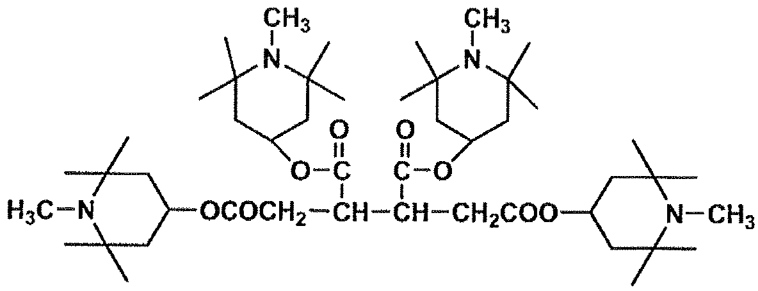

Structural Formula (47)

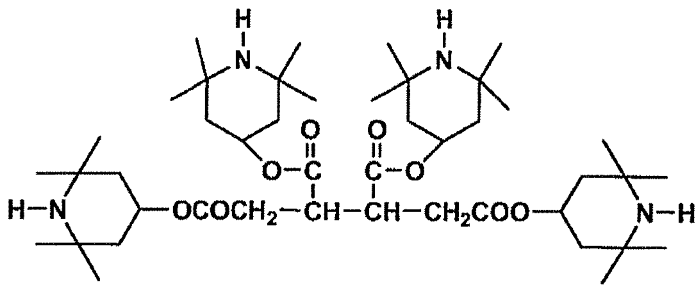

Structural Formula (48)

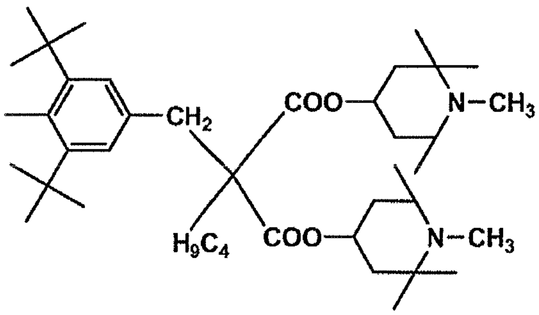

Structural Formula (49)

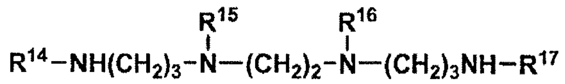

wherein

$R^{14}$,$R^{15}$,$R^{16}$,$R^{17}$: —H or 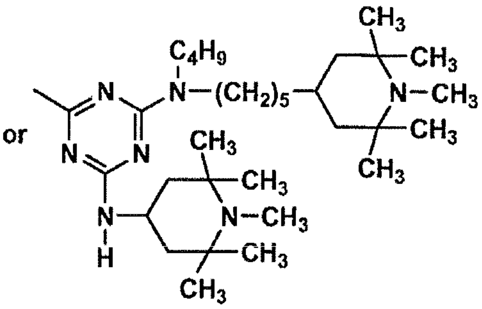

In the above Formula, a compound in which all of $R^{14}$, $R^{15}$, $R^{16}$ and $R^{17}$ is hydrogen atom is excluded.

Structural Formula (50)

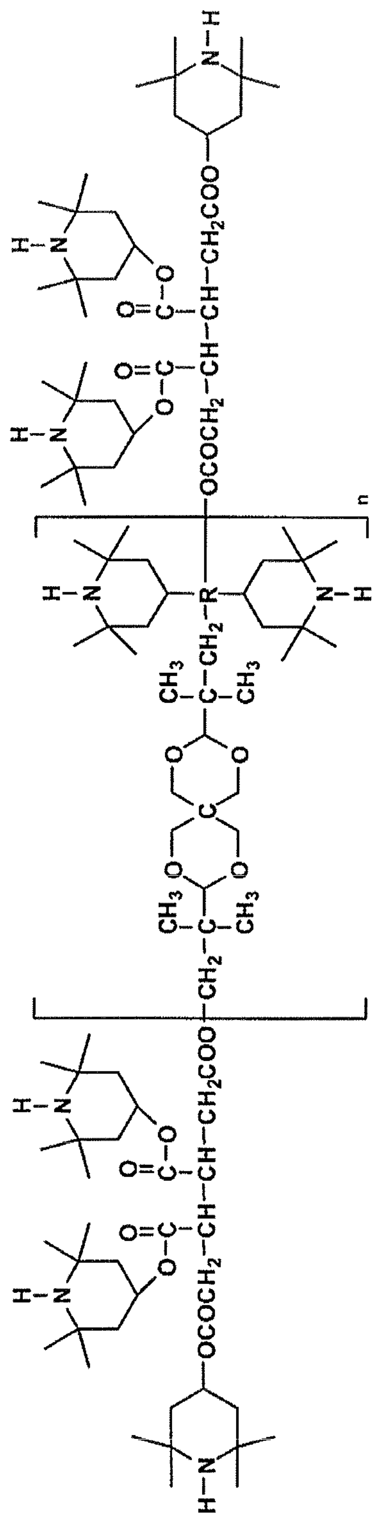

R is an organic residue group of Structural Formula (51) shown below Structural in the Structural Formula (50).

Structural Formula (51)

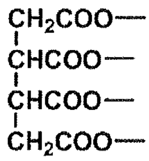

Structural Formula (52)

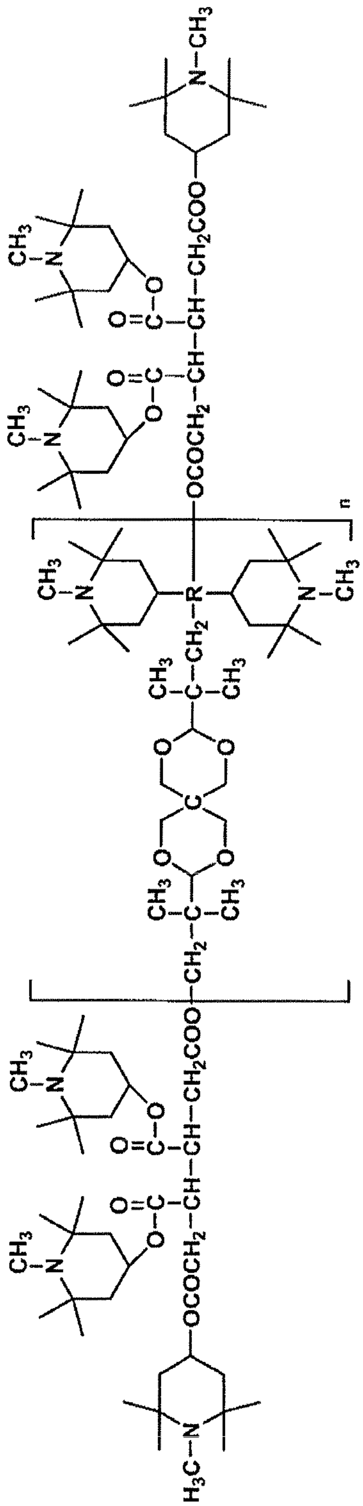

R is an organic residue group of Structural Formula (53) shown below in the Structural Formula (52).

Structural Formula (53)

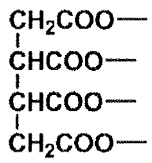

Structural Formula (54)

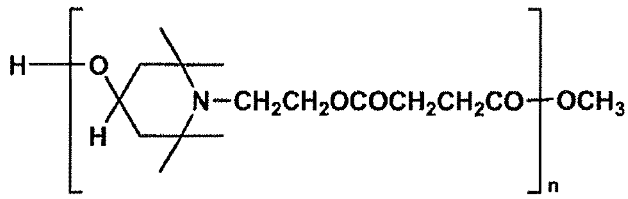

Structural Formula (55)

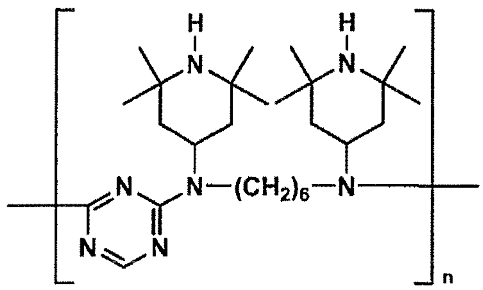

Structural Formula (56)

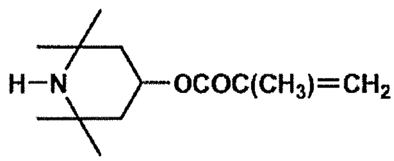

Structural Formula (57)

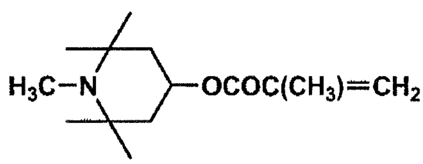

It is true that curing performance is improved by addition of the above mentioned ultraviolet absorbing agent or the light stabilizer, however, coloration may be accompanied during the curing depending kind of the compounds.

Benztriazole type ultraviolet absorbing agent is preferable among the above mentioned ultraviolet absorbing agent or the light stabilizer, in consideration of improving effect to resistance to weather performance of cured material and coloration of an allyl ester type resin composition (IV) during curing.

Further preferable examples are those having a hindered phenol structure in a molecule such as Structural

Formula (21) to Structural Formula (25), Structural Formula (27), Structural Formula (31), Structural Formula (33) and Structural Formula (34), or those having a polymerizable unsaturated group in a molecule such as Structural Formula (35).

The ultraviolet absorbing agent and the light stabilizer may be used singly or plural, further one or more of each kind in combination.

The amount of to be used of is preferably 0.001 % by weight to 2 % by weight with respect to the total curable component, and more preferably 0.05 % by weight to 1.5 % by weight. When the adding amount is not more than 0.05 % by weight, degradation preventing effect is not displayed sufficiently, and, in case of employing exceeding 2 % by weight it is not preferable to consider coloration during curing and economical view point.

(3.1.1.5) Allyl Ester Type Resin Composition (V)

The allyl ester type resin composition (V) is a compound containing 0.01 parts by weight to 5 parts by weight of an anti-oxidizing agent with respect to 100 parts by weight of total curable component in any of the allyl ester type resin composition (I) to (IV).

Phenol type anti-oxidizing agent, phosphite type anti-oxidizing agent, thioether type anti-oxidizing agent, etc., may be generally employed as the anti-oxidizing agent. These anti-oxidizing agents of different types may be used singly respectively, or two or more kinds of same type of anti-oxidizing agent in combination or two or more kinds of different type of anti-oxidizing agents in combination may be used.

Practical examples of the phenol type anti-oxidizing agent include the compounds shown below.

Structural Formula (58)

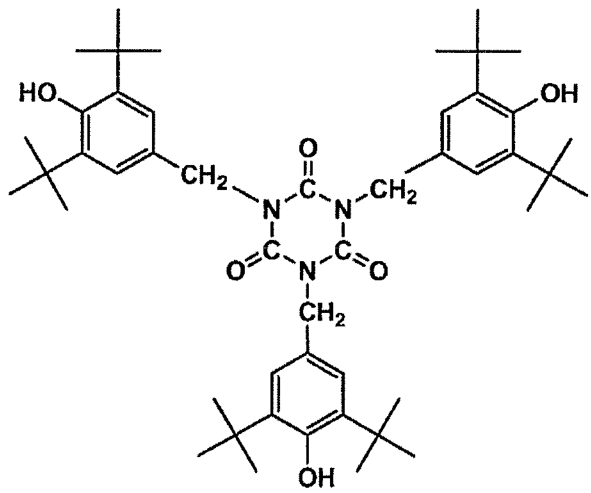

Structural Formula (59)

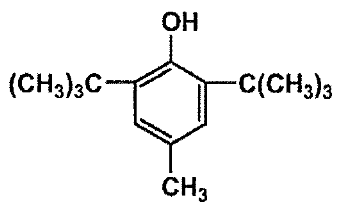

Structural Formula (60)

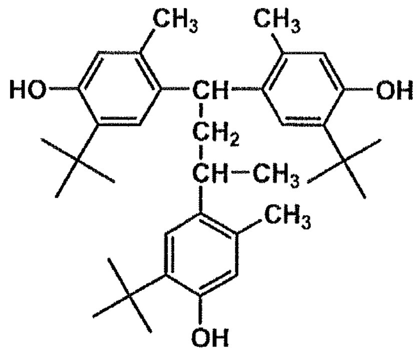

Structural Formula (61)

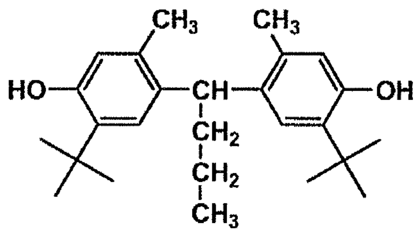

Structural Formula (62)

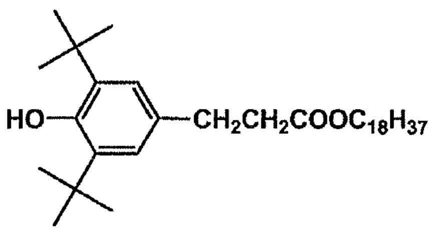

Structural Formula (63)

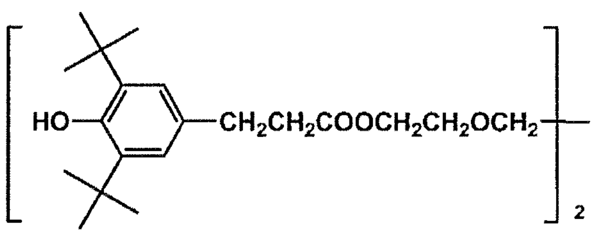

Structural Formula (64)

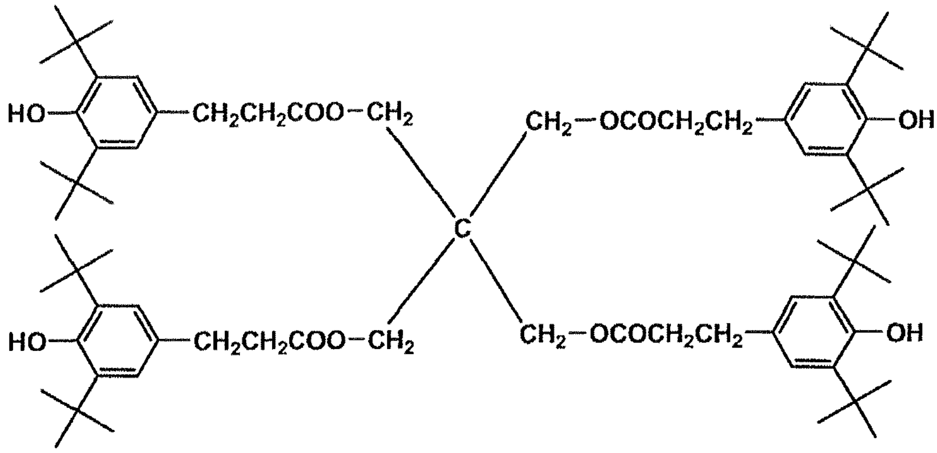

Structural Formula (65)

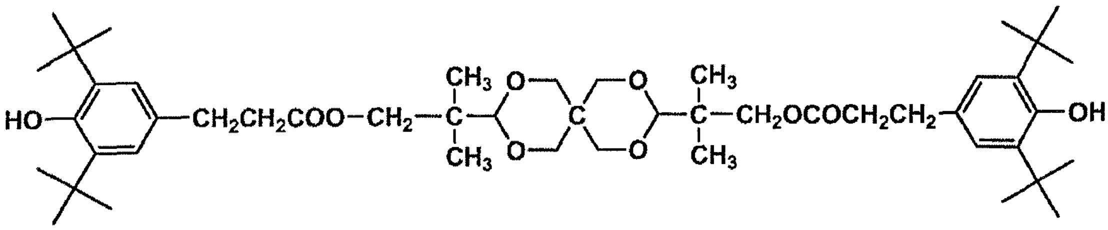

Structural Formula (66)

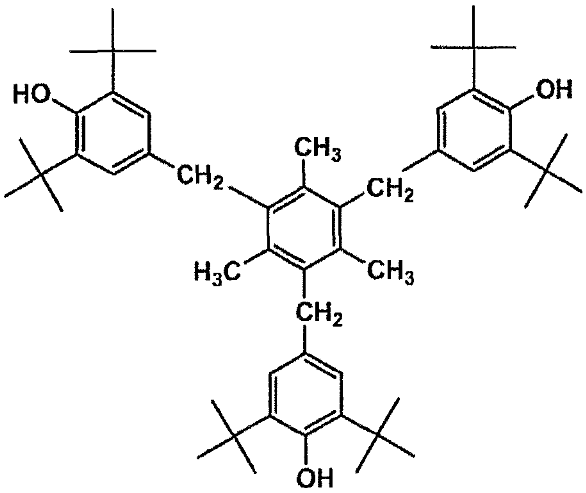

Structural Formula (67)

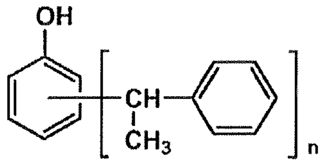

Structural Formula (67) Practical examples of the phosphite type anti-oxidizing agent include the compounds shown below.

Structural Formula (68)

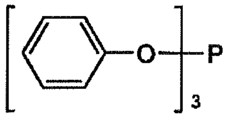

Structural Formula (69)

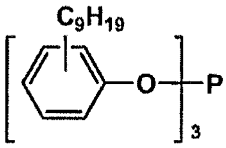

Structural Formula (70)

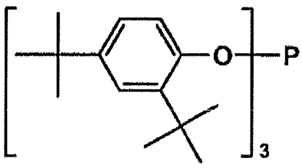

Structural Formula (71)

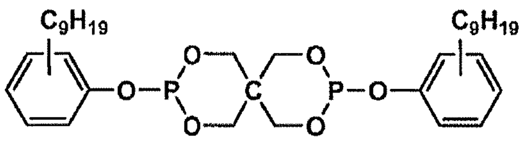

Structural Formula (72)

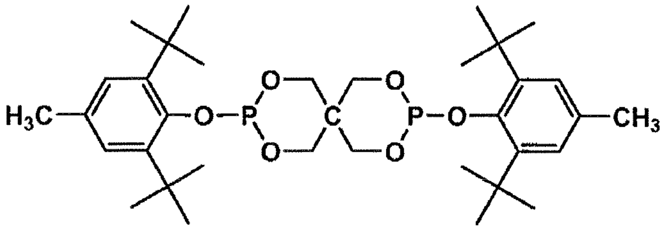

Structural Formula (73)

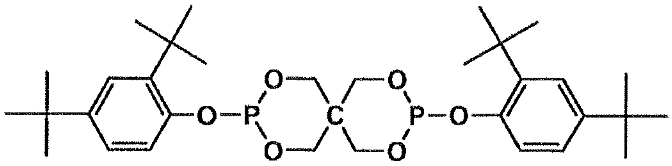

Structural Formula (74)

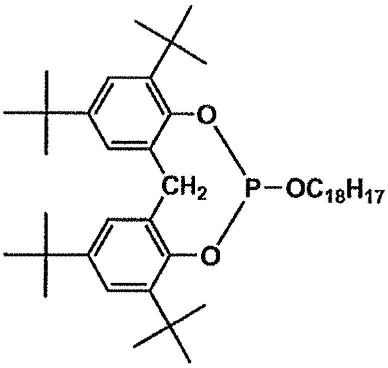

Structural Formula (75)

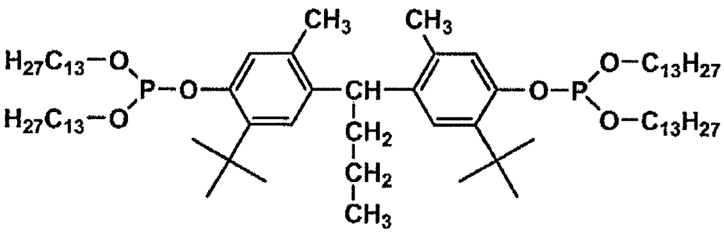

Structural Formula (76)

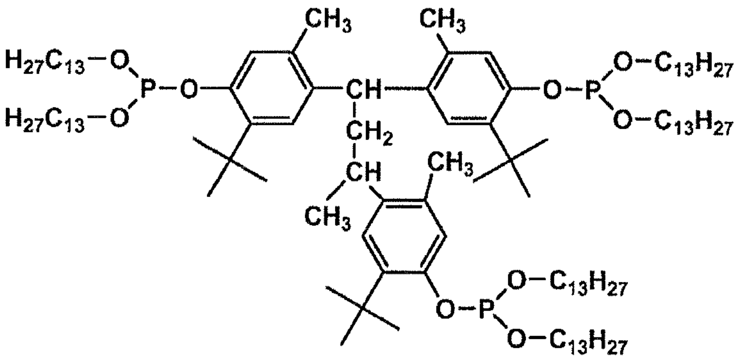

Structural Formula (77)

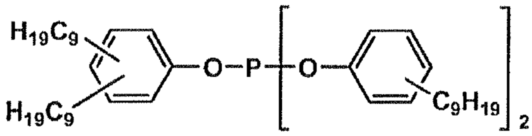

Structural Formula (78)

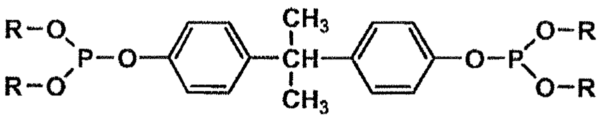

R: $C_{12}$ - $C_{15}$ alkyl group

Structural Formula (79)

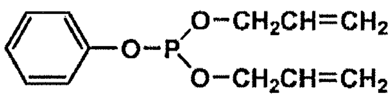

Practical examples of the thioether type anti-oxidizing agent include the compounds shown below.

Structural Formula (80)

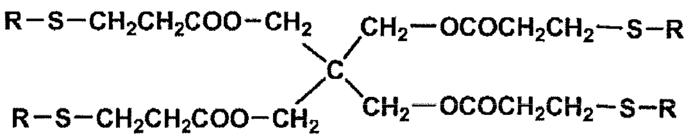

R: $C_{12}$ - $C_{15}$ alkyl group

Structural Formula (81)

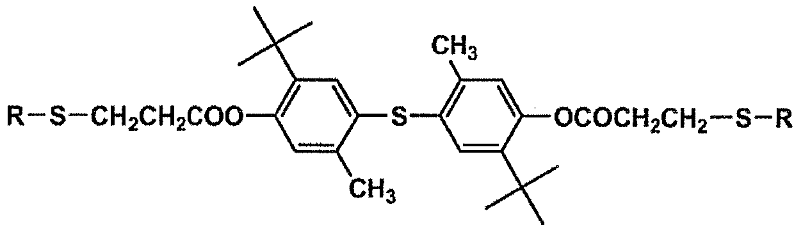

R: $C_{12}$ - $C_{15}$ alkyl group

Structural Formula (82) $H_{25}C_{12}\text{-}OCOCH_2CH_2\text{-}S\text{-}CH_2CH_2COO\text{-}C_{12}H_{25}$

Structural Formula (83) $H_{27}C_{13}\text{-}OCOCH_2CH_2\text{-}S\text{-}CH_2CH_2COO\text{-}C_{13}H_{27}$

Structural Formula (84) $H_{29}C_{14}\text{-}OCOCH_2CH_2\text{-}S\text{-}CH_2CH_2COO\text{-}C_{14}H_{29}$

Structural Formula (85) $H_{37}C_{18}\text{-}OCOCH_2CH_2\text{-}S\text{-}CH_2CH_2COO\text{-}C_{18}H_{37}$

Phosphite type anti-oxidizing agent is preferable among these anti-oxidizing agents in consideration that one causing no coloring and no curing inhibition is preferable. More preferably, the phosphite type anti-oxidizing agent, in which an aryloxy group bonds to a common phosphorus atom together with an alkyloxy or alkenyloxy group such as Structural Formula (71) to Structural Formula (76), Structural Formula (78) and Structural Formula (79), is preferable.

These anti-oxidizing agents may be used in combination with the ultraviolet absorbing agent or the light stabilizer.

An amount to be used of the anti-oxidizing agent is preferably 0.01 % by weight to 5 % by weight with respect to total curable component, and more preferably, 0.1 % by weight to 3 % by weight. When the adding amount is not more than 0.01 % by weight, degradation preventing effect is not sufficiently displayed, and it is not preferable to used exceeding 5 % by weight in economical consideration.

Further, fluorescent whitening agent etc., such as 2,5-bis[5-t-butylbenzoxazolyl(2)]thiophene etc., may be added to the allyl ester type resin composition.

(3.1.1.6) Allyl Ester Type Resin Composition (VI)

The allyl ester type resin composition (VI) is one containing at least one kind of radical polymerization initiator in an amount of 0.1 parts by weight to 10 parts by weight with respect to total curable component 100 parts by weight of any one of the an allyl ester type resin composition (I) to (V).

It is possible and preferable to add a radical polymerization initiator to the allyl ester type resin composition (VI)as a curing agent.

The radical polymerization initiator available to add to the allyl ester type resin composition (VI) is not particularly limited. Those known conventionally may be used as far as they do not adversely affect to property of material of plastic lens as obtained by curing such as an optical property.

The radical polymerization initiator used in the allyl ester type resin composition is preferably, however, soluble in the other component contained in a composition to be cured, and generates free radical at 30 °C to 120 °C. Practical examples of radical polymerization initiator available to use include diisopropyl peroxy dicarbonate, dicyclohexyl peroxy dicarbonate, di-n-propyl peroxy dicarbonate, di-sec-butyl peroxy dicarbonate, t-butylperbenzoate etc., and these are not limitative. The preferable is a radical polymerization initiator having a structure represented by shown below Formula (7) in view of curing property.

Formula (7)

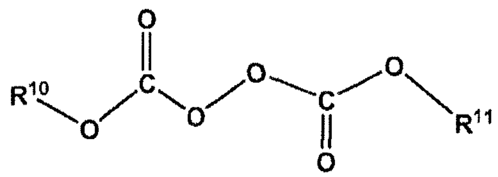

(In the formula, $R^{10}$ and $R^{11}$ independently represent a group selected from an alkyl group and a substituted alkyl group having 1 to 10 carbon atoms, a phenyl group and substituted phenyl group.)

Practical examples of radical polymerization initiator represented by Formula (7) include di-n-propyl peroxy dicarbonate, diisopropylperoxy dicarbonate, bis(4-t-butylcyclohexyl)peroxy dicarbonate, di-2-ethoxyethylperoxy dicarbonate, di-2-ethyhexylperoxy dicarbonate, di-3-methoxybutylperoxy dicarbonate, di-sec-butylperoxy dicarbonate and di (3-methyl-3-methoxybutyl) peroxy dicarbonate.

Preferable examples among them include di-n-propyl peroxy dicarbonate, diisopropylperoxy dicarbonate, di-2-ethoxyethylperoxy dicarbonate, di-2-ethyhexylperoxy dicarbonate, di-(3-methyl-3-methoxybutyl) peroxy dicarbonate, and more preferably diisopropyl peroxy dicarbonate.

An adding amount of the radical polymerization initiator is 0.1 parts by weight to 10 parts by weight, preferably 1 part by weight to 5parts by weight with respect to total curable component 100 parts by weight contained in the allyl ester type resin composition (I) to (V). There is a possibility that the curing of the composition is insufficient in case of not more than 0.1 parts by weight. It is not preferable from economical view to add exceeding 10 parts by weight.

Viscosity of the allyl ester type resin composition (I) to (VI) is not more than 500 mPa·s at 25 °C in general, and preferably not more than 300mPa·s in consideration of filtering property (namely, filtering rate) and workability of casting into mould (namely, easiness of casting into moulding and filling speed) of the composition.

The term of "viscosity" is measured by a rotating viscosimeter, detail of which is described in Iwanami Rikagaku Jiten (Dictionary of Physics and Chemistry), 3rd Ed., published on June 1, 1977.

The allyl ester type resin composition (I) to (VI) may incorporate with additives such as coloring agent, for example, a dye and a pigment, and a releasing agent, usually used for improving the plastic lens.

The coloring agent includes, for example, an organic pigment such as anthraquinone type, azo type, carbonium type, quinoline type, quinone imine type, indigoid type and phthalocyanine type, an organic dye such as azoic dye and sulfide dye, and an inorganic pigment such as titanium yellow, yellow iron oxide, zinc chromate, chrome orange, molybdate orange, cobalt violet, cobalt blue, cobalt green, chromium oxide, titanium oxide, zinc sulfide and carbon black.

The releasing agent includes such as steric acid, butylstearate, zinc stearate, steric acid amide, fluorine type compounds and silicone compounds.

Total amount of the additives such as coloring agent such as dye and pigment, the releasing agent is preferably not more than 1 % by weight with respect to total curable resin component contained in the allyl ester type resin composition.

Conventionally known composition of the allyl ester type resin composition described in, for example, JP-A 2003-66201 can be employed.

(3.1.2) (Poly)ester(meth)acrylate Type Composition

The (poly)ester(meth)acrylate type composition is a resin composition containing (poly) ester(meth)acrylate as a main component.

The (poly)ester(meth)acrylate is (meth)acrylate having one or more ester bonds in a backbone, and preferably includes mono-function (poly)ester(meth)acrylates such as alicyclic modified neopetylglycol(meth)acrylate (R-629 or R-644, manufactured by NIPPON KAYAKU CO.), caprolactone modified 2-hydroxyethyl(meth)acrylate, ethyleneoxide and/or propyleneoxide modified phthalic acid(meth)acrylate, ethyleneoxide modified succinic acid(meth)acrylate and caprolactone modified tetrahydrofuryl(meth)acrylate; pivalic acid ester neopentylglycol di(meth)acrylate, caprolactone modified hydroxypivalic acid ester neopentylglycol di(meth)acrylate, epichlorohydrin modified phthalic acid di(meth) acrylate; mono, di or tri(meth)acrylate of triol obtained by adding one or more mol of cyclic lactone compound such as ε-caprolactone, γ-butyrolactone, δ-valerolactone and methylvalerolactone to one mol of trimethylolpropane or glycerin; mono, di, tri or tetra(meth)acrylate of triol obtained by adding o one or more mol of cyclic lactone compound such as ε-caprolactone, γ-butyrolactone δ-valerolactone and methylvalerolactone to one mol of pentaerythritol or ditrimethylolpropane; mano(meth)acrylate or poly(meth)acrylate of polyalcohol such as triol, tetraol, pentaol and hexaol obtained by adding one or more mol of cyclic lactone compound such as ε-caprolactone, γ-butyrolactone, δ-valerolactone and methylvalerolactone to one mol of dipentaerythritol; (meth)acrylate of polyester polyol composed of a diol component such as (poly)ethyleneglycol, (poly)propyleneglycol, (poly)tetramethyleneglycol, (poly)butyleneglycol, (poly)pentanediol, (poly)methylpentanediol and (poly)hexanediol and a polybasic acid such as maleic acid, fumaric acid, succinic acid, adipic acid, phthalic acid, hexahydrophthalic acid, tetrahydrophthalic acid, itaconic acid, citraconic acid, HET acid, HIMIC acid, Chlorendic acid, dimer acid, alkenyl succinic acid, sebasic acid, azelaic acid, 2,2,4-trimethyladipic acid, 1,4-cyclohexane dicarboxylic acid, terephthalic acid, 2-sodium sulfoterephthalic acid, 2-potassium sulfoterephthalic acid, isophthalic acid, 5-sodium sulfoisophthalic acid, 5-potassium sulfoisophthalic acid, orthophthalic acid, 4- sulfophthalic acid, 1,10-decamethylenedicarboxylic acid, muconic acid, oxalic acid, malonic acid, glutanic acid, trimellitic acid and pyromellitic acid; and polyfunctional (poly) ester(meth)acrylates of the above described diol component, polybasic acid and (meth)acrylate of cyclic lactone modified polyester diol composed of ε-caprolactone, γ-butyrolactone, δ-valerolactone or methylvalerolactone.

(3.1.3) Urethane(meth)acrylate Type Composition

The urethane(meth)acrylate type composition is a resin composition containing urethane(meth)acrylate as a main component.

The urethane(meth)acrylate is (meth)acrylate having at least one urethane bond in a backbone, and preferably a compound obtained by a reaction of a hydroxy compound having at least one (meth)acryloyloxy group with an isocyanate compound.

The hydroxy compound having at least one (meth)acryloyloxy group described above is preferably, for example, various kinds of (meth)acrylate compounds having a hydroxy group such as 2-hydroxyethyl (meth)acrylate, 2-hydroxy propyl(meth)acrylate, 2-hydroxy butyl(meth)acrylate, 3-hydroxy butyl(meth)acrylate, 4-hydroxy butyl(meth)acrylate, cyclohexane dimethanol mono(meth)acrylate, polyethyleneglycol mono(meth)acrylate, polypropyleneglycol mono(meth) acrylate, trimethylolpropane di(meth)acrylate, trimethylolethane di(meth)acrylate, pentaerythritol tri(meth)acrylate or glycidyl(meth)acrylate-(meth)acrylic acid adduct and 2-hydroxy-3-phenoxypropyl(meth)acrylate; and ring opening reaction product of above described (meth)acrylate compound having hydroxy group with ε-caprolactone.

The isocyanate compound described above includes, for example, aromatic diisocyanates such as p-phenylenediisocyanate, m-phenylenediisocyanate, p-xylenediisocyanate, m-xylenediisocyanate, 2,4-tolylenediisocyanate, 2,6-tolylenediisocyanate, 4,4'-diphenylmethanediisocyanate, 3,3'-dimethyldiphenyl-4,4'-diisocyanate, 3,3'-diethyldiphenyl-4,4'-diisacyanate and naphthalene diisocyanate;
aliphatic or alicyclic diisocyanates such as isophoronediisocyanate, hexamethylenediisocyanate, 4,4'-dicyclohexylmethanediisocyanate, hydrogenated xylenediisocyanate, norbornene diisocyanate and lysine diisocyanate;
polyisocyanates such as one or more biuret body of isocyanate monomer, and isocyanurate body trimerizing above described diisocyanate compound; and polyisocyanates obtained by urethane forming reaction of these isocyanate compounds with various kinds of polyols.

Polyols used as a raw material in a preparation of above described polyisocyanate include, (poly)alkyleneglycols such as (poly)ethyleneglycol, (poly)propyleneglycol, (poly)butyleneglycol and (poly)tetramethyleneglycol; modified body of the alkyleneglycols such as ethyleneglycol, propanediol, propyleneglycol, tetramethyleneglycol, pentamethyleneglycol, hexanediol, neopetylglycol, glycerin, trimethylolpropane, pentaerythritol, diglycerin, ditrimethylolpropane and dipentaerythritol, for example, ethyleneoxide modified body, propyleneoxide modified body, butyleneoxide modified body, tetrahydrofuran modified body, ε-caprolactone modified body, γ-butyrolactone modified body, δ-valerolactone modified body and methylvalerolactone modified body; hydrocarbon type polyols such as a copolymer of ethyleneoxide with propyleneoxide, a copolymer of propyleneglycol with tetrahydrofuran, a copolymer of ethyleneglycol with tetrahydrofuran, polyisopreneglycol, hydrogenated polyisopreneglycol, polybutadiene glycol, hydrogenated polybutadiene glycol; aliphatic polyester polyols, which are esterify reaction product of aliphatic dicarboxylic acid such as adipic acid and dimer acid with polyol such as neopentylglycol and methylpentanediol; aromatic polyester polyols which are esterify reaction product of aromatic dicarboxylic acid such as terephthalic acid with polyol such as neopentylglycol; polycarbonate polyols; acryl polyols; polyhydroxy group compounds such as polytetramethylenehexaglyceryl ether (tetrahydrofuran modified body of hexaglycerin); mono and polyhydroxy group containing compound of terminal ether group above described polyhydroxy group containing compound; polyhydroxy group containing compounds which are obtained by esterify reaction of above described polyhydroxy group containing compound with dicarboxylic acid such as fumaric acid, phthalic acid, isophthalic acid, itaconic acid, adipic acid, sebacic acid and maleic acid; and polyhydroxy group containing compound such as monoglyceride obtained by ester exchange reaction of polyhydroxy group compound such as glycerin with fatty acid ester from animals or plants.

(3.1.4) Epoxy(meth)acrylate Type Composition

The epoxy(meth)acrylate type composition is a resin composition containing epoxy(meth)acrylate as a main

component.

The epoxy(meth)acrylate is (meth)acrylate obtained by reacting one or more functional epoxide with (meth) acryl acid, wherein the epoxide is, for example, epichlorohydrin modified hydrogenated bisphenol type epoxy resin synthesized by (methyl)epichlorohydrin with hydrogenated bisphenol A, hydrogenated bisphenol S, hydrogenated bisphenol F, ethyleneoxide of these, or propyleneoxide modified body; alicyclic epoxy resin such as 3,4-epoxy cyclohexyl methyl-3,4-epoxycyclohexane carboxylate and bis-(3,4-epoxy cyclohexyl)adipate; epoxy resin alicyclic epoxide such as epoxy resin containing heterocycle such as triglycidylisocyanurate; epichlorohydrin modified bisphenol type epoxy resin synthesized from (methyl) epichlorohydrin with bisphenol A, bisphenol S, bisphenol F, their ethyleneoxide, and propyleneoxide modified body; phenol novolak type epoxy resin; creosol novolak type epoxy resin; epoxylated body of various kinds of dicyclopentadiene modified phenol resin obtained by a reaction of dicyclopentadiene with various kinds of phenols; epoxylated body of 2,2',6,6'-tetramethylbiphenol, aromatic epoxides such as phenyl glycidylether; (poly)glycidylethers of glycols such as (poly)ethyleneglycol, (poly)propyleneglycol, (poly)butyleneglycol, (poly)tetramethyleneglycol, neopetylglycol; (poly)glycidylethers of alkyleneoxide modified body of glycols; (poly)glycidylethers of aliphaticpolyalcohols such as trimethylolpropane, trimethylolethane, glycerin, diglycerin, erythritol, pentaerythritol, sorbitol, 1,4-butanediol and 1,6-hexanediol; alkylene type epoxide such as an alkyleneoxide modified body aliphaticpolyalcohol of (poly) glycidylether; glycidylester of carboxylic acid such as adipic acid, sebacic acid, maleic acid, itaconic acid, and glycidylether of polyester polyol composed of polyalcohol and polycarboxylic acid and polyester polyol; copolymer such as glycidyl (meth)acrylate and methylglycidyl(meth)acrylate; and aliphaticepoxy resin such as glycidylester of higher fatty acid, epoxylated linseed oil, epoxylated soy bean oil, epoxylated caster oil and epoxylated polybutadiene.

A conventionally known compounds can be used for the above mentioned (poly) ester(meth)acrylate type composition, urethane(meth)acrylate type composition and epoxy(meth)acrylate type composition such as described in JP-A 2006-131876.

(3.1.5) Epoxy Type Resin Composition

The epoxy type resin composition is a resin composition containing epoxy resin as a main component.

Examples of the main component of the epoxy resin include, a polyfunctional epoxy resin composed of glycidyletherified polyphenol compound, a polyfunctional epoxy resin composed of glycidyletherified various kinds of novolak resin, alicyclic epoxy resin, aliphatic type epoxy resin, heterocyclic epoxy resin, glycidylester type epoxy resin, glycidylamine type epoxy resin and an epoxy resin composed of glycidylized halogenated phenol.

The polyfunctional epoxy resin of glycidyletherified compound of polyphenol compound includes an polyfunctional epoxy resin of glycidyletherified polyphenol compound such as another bisphenol A, bisphenol F, bisphenol S, 4,4'-biphenylphenol, tetramethyl bisphenol A, dimethyl bisphenol A, tetramethyl bisphenol F, dimethyl bisphenol F, tetramethyl bisphenol S, dimethyl bisphenol S; tetramethyl-4,4'-biphenol, dimethyl-4,4'-biphenylphenol, 1-(4-hydroxy phenyl)-2-(4-(1,1-bis-(4-hydroxyphenyl)ethyl) phenyl) propane, 2,2'-methylene-bis(4-methyl-6-tert-butylphenol), 4,4'-butylidene-bis(3-methyl-6-tert-butylphenol), trishydroxy phenyl methane, resorcinol, hydroquinone, pyrogallol, and phenols having a diisopropylidene skeleton, phenols having fluorene skeleton such as 1,1-di-4-hydroxy phenyl fluorene and glycidyletherified compound of polyphenol compound such as polybutadiene.

The polyfunctional epoxy resin of glycidyletherified composition of the various kinds of novolak resin includes a glycidyletherified novolak resin composed from a raw material of various kinds of phenol such as phenol, creosols, ethylphenols, butyl phenols, octylphenols, bisphenol A, bisphenol F, bisphenol S and naphtols, a phenol novolak resin containing xylene skeleton, a phenol novolak resin containing dicyclopentadiene skeleton, a phenol novolak resin containing biphenyl skeleton and a phenol novolak resin containing fluorene skeleton.

The alicyclic epoxy resin includes an alicyclic epoxy resin having an aliphatic such as cyclohexane skeleton, such as 3,4-epoxy cyclohexyl ethyl-3',4'- cyclohexyl carboxylate, aliphatic type epoxy resin includes glycidylethers of polyalcohol such as 1,4-butanediol, 1,6-hexanediol, polyethyleneglycol, polypropyleneglycol, pentaerythritol, xylene glycol, the heterocyclic epoxy resin includes a heterocyclic epoxy resin having heterocyclic ring such as isocyanuric ring and hydantoin ring, the glycidylester type epoxy resin includes an epoxy resin composed of carboxylic acids such as hexahydrophthalic acid diglycidylester and tetrahydrophthalic acid diglycidylester, the glycidylamine type epoxy resin includes an epoxy resin in which amines are glycidylized such as aniline, toluidine, p-phenylenediamine, m-phenylenediamine, diaminodiphenylmethane derived body, and diaminomethylbenzene derived body, and the epoxy resin in which halogenated phenols are glycidylized includes such as brominated bisphenol A, brominated bisphenol F, brominated bisphenol S, brominated phenol novolak, brominated creosol novolak, chlorinated bisphenol S and chlorinated bisphenol A. The epoxy resin may be liquid state or solid state in its shape, suitable one is selected in consideration of curing temperature, melt viscosity and workability. Solid epoxy resin is used as it is molt with bisphenol type liquid state epoxy resin by heating, and it is preferable to have mixing ratio so that the viscosity after melting by heat is not more than 500,000 mPa·s in view of workability.

When the epoxy resin is used, without particularly limitation, one having minimized coloration property is preferable in view of transparency. Usually employed Examples include polyfunctional epoxy resin of glycidylized compound of phenols such as bisphenol A, bisphenol F, bisphenol S, 4,4'-biphenylphenol, tetramethyl-4,4'-biphenol, 1-(4-hydroxy phenyl)-2-(4-(1,1-bis-(4-hydroxyphenyl)ethyl)phenyl) propane, trishydroxy phenyl methane, resorcinol, phenols having 2,6-di-tert-butylhydroquinone and phenols having diisopropylidene skeleton, glycidyl etherified compound of various kinds of novolak resin such as novolak resins composed of raw materials of various kinds of phenol such as phenol, creosols, bisphenol A, bisphenol S, naphtols, a phenol novolak resin containing a dicyclopentadiene skeleton, a phenol novolak resin containing a biphenyl skeleton, a phenol novolak resin containing a fluorene skeleton, a alicyclic epoxy resin having a cyclohexane skeleton such as 3,4-epoxy cyclohexyl methyl-3',4'- cyclohexyl carboxylate, 1,6-hexanediol, polyethyleneglycol, glycidylethers of polypropyleneglycol, triglycidylisocyanurate, hexahydrophthalic acid and diglycidylester. These epoxy resin may be used in combination with one of more species in mixture, if necessary taking into heat-resisting endowing properties consideration.

Content ratio of the epoxy resin component in the composition depends on the equivalent amount of used epoxy resin, and, epoxy resin as a whole containing bisphenol type liquid state epoxy resin is 30% by weight to 80% by weight, preferably around 30% by weight to around 70% by weight in the composition.

It is also preferable that liquid state acid anhydride is added to the epoxy type resin composition as a curing agent. The liquid state acid anhydride is liquid state at normal temperature, and having transparency, practical examples include, hexahydro phthalic acid anhydride, methylhexahydro phthalic acid anhydride, methyltetrahydro phthalic acid anhydride, dodecyl succinic acid anhydride, methyl nadic acid anhydride, a mixture of methylhexahydro phthalic acid anhydride and hexahydro phthalic acid anhydride, methylnorbornane-2,3-dicarboxylic acid and 2, 4-diethylglutaric acid anhydride.

The preferable examples among these include dicarboxylic acid anhydride having cyclohexane skeleton and/or norbornane skeleton, for example, available from New Japan Chemical Co., Ltd., in trade names such as MH-700 (a mixture of methylhexahydro phthalic acid anhydride and hexahydro phthalic acid anhydride) and HNA-100 (methylnorbornane-2,3-dicarboxylic acid anhydride).

The other curing agent may be used in combination with liquid state acid anhydride if it does not prevent the property of material such as transparency. The other curing agent can be used without particularly limitation, for example, those usually used as a curing agent of the epoxy resin such as acid anhydride type curing agent, phenol type curing agent, and amine type curing agent.

The practical examples of the other acid anhydride type curing agent include aromatic carboxylic acid anhydride such as phthalic acid anhydride, trimellitic acid anhydride, pyromellitic acid anhydride, benzophenone tetracarboxylic acid anhydride, ethyleneglycol anhydrous trimellitic acid anhydride and biphenyltetracarboxylic acid anhydride, aliphatic carboxylic acid anhydride such as azelaic acid, sebacic acid and dodecane diacid, and alicyclic carboxylic acid anhydride such as tetrahydrophthalic acid anhydride, nadic acid anhydride, HET acid anhydride and HIMIC acid anhydride.

The phenol type curing agent includes bisphenol A, bisphenol F, bisphenol S, 4,4'-biphenylphenol, tetramethyl bisphenol A, dimethyl bisphenol A, tetramethyl bisphenol F, dimethyl bisphenol F, tetramethyl bisphenol S, dimethyl bisphenol S, tetramethyl-4,4'-biphenol, dimethyl-4,4'-biphenylphenol, 1-(4-hydroxy phenyl)-2-(4-(1,1-bis-(4-hydroxyphenyl)ethyl)phenyl)propane, 2,2'-methylene-bis(4-methyl-6-tert-butylphenol), 4,4'-butylidene-bis(3-methyl-6-tert-butylphenol), trishydroxy phenyl methane, resorcinol, hydroquinone, pyrogallol, diisopropylidene, phenols having terpene skeleton, phenols having fluorene skeleton such as 1,1-di-4-hydroxy phenyl fluorene, phenolic polybutadiene, various kinds of novolak resin such as novolak resin prepared from a raw material of various kinds of phenol such as phenol, creosols, ethylphenols, butylphenols, octylphenols, bisphenol A, bisphenol F, bisphenol S, naphtols, terpene diphenols, xylene skeleton containing phenol novolak resin, dicyclopentadiene skeleton containing phenol novolak resin, biphenyl skeleton containing phenol novolak resin, fluorene skeleton containing phenol novolak resin and furan skeleton containing phenol novolak resin.

It is preferable to add a carboxylic acid ended polyester solid resin to the epoxy type resin composition. The carboxylic acid ended polyester solid resin is a solid resin having carboxylic acid at the ends which is prepared by reacting polycarboxylic acid (anhydride) with the alcoholic hydroxy group at the ends of polyester resin obtained by anhydration polymerization reaction of one or more polycarboxylic acid with one or more polyalcohol. The polycarboxylic acid includes 2-valent carboxylic acid such as isophthalic acid, terephthalic acid, succinic acid, fumaric acid, adipic acid, hexahydrophthalic acid and tetrahydrophthalic acid, and 3 or more-valent carboxylic acid such as trimellitic acid. The polyalcohol includes 2-valent alcohol such as ethyleneglycol, neopetylglycol, diethyleneglycol, polyethyleneglycol and 1,3-propyleneglycol, and 3 or more-valent alcohol such as pentaerythritol. The carboxylic acid ended polyester solid resin used in the epoxy type resin composition are available as trade names of U-PICACOAT GV230, U-PICACOAT GV250 (Japan U.PICA Company, Ltd) easily in the market.

The carboxylic acid ended polyester solid resin works as a curing agent of epoxy resin, and is used by heat dissolving with the above described liquid state acid anhydride curing agent.

Certain degree of viscosity can be maintained and about same shape in solid state can be maintained by mixing with liquid state acid anhydride which has generally, low viscosity, and therefore, property of material such as resistance

to humidity and bent property is improved. It is necessary to select one dissolving at a temperature at which the low molecular weight liquid state acid anhydride described above does not volatilize in this instance. Practically, the softening point is 70 °C to 120 °C, preferably 70°C to 110°C, and more preferably 70 °C to 105 °C. The measurement of softening point is conducted by the ball and ring method.

It is preferable to select carboxylic acid ended polyester solid resin having acid value of 60 to 100 mgKOH/g. When the acid value is not more than 60 mgKOH/g, crosslinking density of the cured material is low, and may affect resistance to humidity and heat-resisting properties adversely. In case of not less than 100 mgKOH/g, coefficient of elasticity of the cured material is high, and may affect anti-heat recycle property and anti-solder reflow property adversely. The measurement of the acid value is conducted according to an acid base titration method by KOH as usually employed.

It is also necessary to select one having good color so as not to defect tone transparency, practically, having Gardner method of 3 or less, preferably 2 or less, and more preferably lor less. The carboxylic acid ended polyester solid resin can be obtained by a trade name of GV-250 etc. from Japan U.PICA Company, Ltd. The hue decision by Gardner method is conducted in accordance with Gardner color standard stipulated by JIS K 5600.

Content ratio to be used of carboxylic acid ended polyester solid resin is 10 to 80% by weight, preferably 20 to 70% by weight, and preferably 30 to 60% by weight with respect to total amount of the curing agent.

Content ratio to be used of the curing agent of a mixture of acid anhydride and carboxylic acid ended polyester solid resin is 0.4 to 1.2 equivalent amount, preferably 1.6 to 1.1 equivalent amount, and more preferably 0.8 to 1.0 equivalent amount with respect to 1 equivalent amount of epoxy resin as a whole containing bisphenol type liquid state epoxy resin.

It is also preferable to add a curing accelerating agent to the epoxy type resin composition. The curing accelerating agents include those usually working as a curing accelerating agent of epoxy resin. Two or more species of accelerators may be used in combination in the epoxy type resin composition of the present embodiment. Practical examples include various kinds of imidazoles such as 2-methylimidazole, 2-phenyl imidazole, 2-undecyl imidazole, 2-heptadecyl imidazole, 2-phenyl -4-methylimidazole, 1-benzyl-2-phenyl imidazole, 1-benzyl-2-methylimidazole, 1-cyanoethyl-2-methylimidazole, 1-cyanoethyl-2-phenyl imidazole, 1-cyanoethyl-2-undecyl imidazole, 2,4-diamino-6(2'-methylimidazole(1'))ethyl-s-triazine, 2,4-diamino-6(2'-undecyl imidazole(1'))ethyl-s-triazine, 2,4-diamino-6(2'-ethyl,4-methylimidazole(1'))ethyl-s-triazine, 2,4-diamino-6(2'-methylimidazole(1'))ethyl-s-triazine-isocyanuric acid adduct, 2:3adduct of 2-methylimidazoleisocyanuric acid, 2-phenyl imidazoleisocyanuric acid adduct, 2-phenyl -3,5-dihydroxymethylimidazole, 2-phenyl -4-hydroxy methyl-5-methylimidazole and 1-cyanoethyl-2-phenyl -3,5-dicyanoethoxy methylimidazole, and salts of these imidazoles with polycarboxylic acid such as phthalic acid, isophthalic acid, terephthalic acid, trimellitic acid, pyromellitic acid, naphthalene dicarboxylic acid, maleic acid and oxalic acid, amides with dicyandiamide etc., Diaz compound such as 1,8-diaza-bicyclo(5.4.0)undecene-7 etc., and phenols of the above described compound, polycarboxylic acids, salts of tetraphenyl borate, or salts of phosphinic acids, ammonium salts such as tetrabutylammonium bromide, cetyltrimethylammonium bromide and trioctylmethylammonium bromide, other phosphines such as triphenyl phosphine and tetraphenyl phosphonium tetraphenyl borate, phenols such as 2,4,6-trisaminomethylphenol etc., amine adducts, and microcapsule type curing accelerating agent in which the curing agents are made to microcapsule, and so on. In the above described accelerator tetraphenyl borate salt of 1,8-diaza-bicyclo(5.4.0) undecene-7 is particularly preferable by a reason of giving transparency, low bent property and stability with time to the cured material. The curing accelerating agent is used in an amount of usually 0.1 to 5 parts by weight to 100 parts by weight of whole epoxy resin containing bisphenol type liquid state epoxy resin. It is preferable to use in an amount of 0.1 to 3 parts by weight from view points of stability with time, coloring property and low bent property.

Conventionally known compounds can be employed for the epoxy type resin composition described above, for example, described in JP-A 2006-335894.

(3.1.6) Silicone Type Resin Composition

The silicone type resin compositions are not specifically limited provided that the resins are formed into a three dimensional network structure via a siloxane bonding skeleton by polymerization reaction by heating, and generally exhibit thermosetting properties when heated for a long period of time at high temperature and have properties wherein softening by heating hardly occurs again once thermally set.

The silicone type resin comprises a polyorganosiloxane resin as a main component in an embodiment of the present invention. The polyorganosiloxane resin composition contains a constituent unit represented by following Formula (9), and its form is any of a chain, a ring, and a network form.

$$(R_1)\ (R_2)\ SiO)_m \qquad (A)$$

In Formula (9), "$R_1$" and "$R_2$" represent a substituted or unsubstituted monovalent hydrocarbon group of the same type or such groups of different type. Specifically, as "$R_1$" and "$R_2$", there are exemplified an alkyl group such as

a methyl group, an ethyl group, a propyl group, or a butyl group, an alkenyl group such as a vinyl group or an allyl group, an aryl group such as a phenyl group or a tolyl group, and a cycloalkyl group such as a cyclohexyl group or a cyclooctyl group; or groups wherein hydrogen atoms bonded to carbon atoms of these groups are substituted with a halogen atom, a cyano group, or an amino group, including, for example, a chloromethyl group, a 3,3,3-trifluoropropyl group, a cyanomethyl group, a γ-aminopropyl group, and an N-(β-aminoethyl)-γ-aminopropyl group. The groups represented by "$R_1$" and "$R_2$" are also a group selected from a hydroxyl group and an alkoxy group. Further, in above Formula (9), "m" represents an integer of at least 50.

Polyorganosiloxane resins are commonly used via dissolution in a hydrocarbon based solvent such as toluene, xylene, or petroleum based solvent; or in a mixture of any of these and a polar solvent. Further, solvents of different compositions may be used provided that these are mutually soluble.

Production methods of a polyorganosiloxane resin are not specifically limited, and any of the methods known in the art are employable. For example, one type of organohalogenosilane or a mixture of two types thereof is subjected to hydrolysis or alcoholysis to obtain the resin. A polyorganosiloxane resin generally contains a silanol group or a hydrolyzable group such as an alkoxy group. These groups are contained at a ratio of 1 to 10% by weight converted as a silanol group equivalent.

These reactions are commonly conducted in the presence of a solvent capable of melting an organohalogenosilane. Further, there is usable a method of synthesizing a block copolymer wherein a straight-chain polyorganosiloxane having a hydroxyl group, an alkoxy group, or a halogen atom at molecular chain terminals is hydrolyzed together with organotrichlorosilane. The thus-prepared polyorganosiloxane resin usually contains residual HCl, and those containing at a ratio of at most 10 ppm, preferably at most 1 ppm, may be used in view of good storage stability in a composition of the embodiment of the present invention.

(3.2) Additive

Various kinds of additive may, if necessary, be incorporated in the above described resin composition. For example, a conventionally known and used thickening agent such as polyamide resin, silica powder, organic bentonite, and acryl oligomer; a defoaming agent and/or a leveling agent such as silicone type, fluorine type and copolymer resin type; a silane coupling agent; a plasticizer such as phthalic acid di-2-ethylhexyl, phthalic acid dinonyl and adipic acid dioctyl; a fire retardant of bromine atom compound such as tetrabromobisphenol A and phosphoric acid ester; an antistatic agent such as fatty acid ester and aliphatic acid amide, and so on, conventionally known and used. The mixing ratio or mixing method of the resin composition with a thickening agent can be optionally selected so that the viscosity of the resin material be 50 to 50,000 mPa·s under measuring condition at 23 °C and 500 Hz.

(3.3) Preparation of Resin Material

Shapes of the material for optical used obtained by curing the resin material are various of the purpose of use and are not particularly limited, and may be, for example, film, sheet, tube, rod coated layer and bulk shape.

The shape forming methods include conventional thermosetting resin forming method and in addition thereto, various forming method such as a cast method, a press method, an injection cast method, a transfer forming method, a coating method and LIM method and conventionally known injection cast method is employed in an embodiment of the present invention.

Moulds such as abraded glass, abraded hard stainless steel plate, abraded stainless steel plate, polycarbonate plate, polyethyleneterephthalate plate and polymethyl methacrylate plate may be employed.

Further, polyethylene terephthalate film, polycarbonate film, polyvinylchloride film, polyethylene film, polytetrafluoroethylene film, polypropylene film, polyimide film etc., may be used to improve releasing property of moulds.

Various kinds of treatments, if necessary, can be applied. For example, defoaming treatment by of centrifuge or depression of the composition or partly reacted composition, treatment to release pressure once during press process and so on to prevent forming voids.

The cured material obtained by the present invention can be used in various kinds of applications of material for optical use and so on.

The material for optical use is generally a material in which light such as visible, infrared, ultraviolet, X ray and laser is transmitted.

More practically, other than a sealing medium for LED of lamp type, SMD, and so on, the following applications can be included;
peripheral material of liquid crystal display device such as a substrate material, a light guiding plate, prism sheet, polarizing plate, phase difference plate, view angle correcting film, adhesion agent, liquid crystal film such as polarizer protection film in the field of a liquid crystal display. A sealing medium, anti-glare film, optical correcting film, housing material, front glass protection film, front glass substitution material, adhesion agent for color PDP (plasma display) which is expected

as a next generation flat panel display; LED mould material, LED sealing medium, front glass protection film, front glass substitution material and adhesion agent used in the LED display device; substrate material, light guiding plate, prism sheet, polarizing plate, phase difference plate, view angle correcting film, adhesion agent, polarizer protection film in the plasma address liquid crystal (PALC) display; front glass protection film, front glass substitution material, adhesion agent in organic EL (electroluminescence) display, various kinds of film substrate, front glass protection film, front glass substitution material, adhesion agent for the field emission display (FED).

Disk substrate material for VD (video disk), CD/CD-ROM, CD-R/RW, DVD-R/DVD-RAM, MO/MD, PD (phase change disk) and optics card, pick-up lens, protection film, a sealing medium and adhesion agent etc., in the field of light recording.

In the field of optical instruments lens material, finder prism, target prism, finder cover, light receiving sensor portion of a still camera; lens and finder of a video camera; projection lens, protection film, a sealing medium, adhesion agent etc., for a projection TV; and lens material, a sealing medium, adhesion agent, film etc., for a light sensing instrument.

In the field of optics parts, fiber material, lens, waveguide, a sealing medium element, adhesion agent etc., of an optical switch peripheral in optical communication system; optical fiber material, ferrule, a sealing medium, adhesion agent etc., in a light connector peripheral; lens, waveguide, a sealing medium of LED, a sealing medium of CCD, adhesion agent etc., in light receiving parts and optical circuit parts; and substrate material, fiber material, a sealing medium of element, adhesion agent etc., in photoelectron integrate circuits (OEIC) peripheral.

Illumination and light guide for a decorating display etc., sensors for industrial use, display and signals etc., digital instrument connection optical fiber for communication infrastructure and inside home in the field of the optical fiber.

Resist material for micro lithography of LSI, very large scale integration material in the semiconductor integrate circuits peripheral material.

Automobile use reflector lamp, baring retainer, gear parts, anticorrosion coating, switch parts, a head lamp, internecine parts , electric equipment parts , various kinds of inside or outside equipment, driving engine, a break oil tank, anticorrosion steel plate for automobile, interior panel, interior parts material, wire harness for protector or binder, fuel pipe, automobile lamp and glass substitution material in the field of automobile and transport machine. Composite glass for rail way cars. A toughness imparting agent of air craft structure material, engine peripheral parts, wire harness for protector or binder and anticorrosion coating.

Interior or finishing material, electric cover, sheet, glass inter layer, glass substitution material, and solar cell peripheral material in the field of architecture. Green house cover film in the agriculture.

Organic EL element peripheral material, substrate material of organic photorefractive element, light amplifying element of photo to photo conversion device, photo-computing element and organic solar cell peripheral, fiber material, a sealing medium of element and adhesion agent in opt electronics organic material in the next generation.

Other applications in material for optical use include a general application in which a thermosetting resin of an epoxy resin is used, for example, adhesion agent, paints, coating agent, moulding material (including sheet, film, FRP etc.), insulating material (including printed board, wire coating, etc.), sealing agent, and additives to a resin etc.

An adhesion agent includes those for civil engineering, architecture, automobile, general business and medical use, as well as adhesion agent for electronics material. Among them material adhesion agent for electronics material includes an interlayer adhesion agent for multiple layer board such as a build up board etc., an adhesion agent for semiconductor use such as a dye bonding agent and under fill, under fill for BGA reinforce, an isotropic electroconductive film (ACF), adhesion agent for mounting anisotropic electroconductive paste (ACP), etc.

Sealing agents include those used for of condenser, transistor, diode, emission diode, IC, LSI, etc., potting sealing of COB, COF, TAB etc., for IC and LSIs, under fill for flip chip etc., BGA, CSP etc., sealing (reinforce under fill) at a time of IC packages mounting etc.

(4) Manufacturing Method of Image Pick-up Device

A manufacturing method of image pick-up device 100 according to the present embodiment is described by referring to Fig. 3.

First substrate module 5 and lens module 6 are assembled. Mount portion 15b of lens holder 15 is inserted and fixed in mounting hole 10a of subsidiary substrate 10, so that bottom end of preliminarily mounted collar parts 17 in lens holder 15 comes into contact with top face of subsidiary substrate 10, whereby camera module 2 is formed, as shown in Fig. 3(a).

Then, camera module 2 and other electronic parts are placing on predetermined mounting position on circuit substrate 1 having preliminarily provided (potted) solder 18 as shown in Fig. 3(b). Thereafter, a belt conveyer etc., on which circuit substrate 1 having camera module 2 and other electronic parts are placed thereon is conveyed to a reflow oven (not shown), a reflow process is performed to the circuit substrate 1 by heating at temperature of around 260 °C as shown in Fig. 3(c). As a result, camera module 2 is mounted on circuit substrate 1 along with electronic parts as solder 18 is molt.

According to the present embodiment described above, even high pressure is applied to the resin material during moulding process, resin material does not leak from a mould since lens 16 is composed of a thermosetting resin material having viscosity of not less than 50 mPa·s under measuring condition at 23 °C and 500 Hz. Therefore, deformation of lens 16 due to a reflow process can be prevented since lens 16 having high resin density can be formed.

Further it is possible to prevent dissolving distortion by a reflow process after the resin material is cured as remaining distortion inside, since lens 16 is composed of a thermosetting resin material having viscosity of not more than 50,000 mPa·s under measuring condition at 23 °C and 500 Hz. Therefore, deformation of lens 16 due to a reflow process can be prevented more certainly.

Further, resin material can be extended sufficiently within a mould in the moulding process since lens 16 is composed of a thermosetting resin material having viscosity of not more than 50,000 mPa·s under measuring condition at 23 °C and 500 Hz. Therefore, lens 16 having fine shapes can be formed.

EXAMPLES

EXAMPLE (1)

Acryl oligomer type thickening agent "ELVACITE" (trade name) manufactured by E. I. du Pont de Nemours and Company was added to an allyl ester type resin composition "CR607" (trade name) manufactured by PPG Industries., Inc., to prepare a heat curable resin material, which was injected to a mould inside with injection pressure of 50 MPA, moulding was conducted by heating at 160 °C for 5 minutes. An adding amount of the thickening agent was adjusted so as to have viscosity of the resin material of 60 mPa·s under measuring condition at 23 °C and 500 Hz.

EXAMPLE (2)

Acryl oligomer type thickening agent "ELVACITE" (trade name) manufactured by E. I. du Pont de Nemours and Company was added to an allyl ester type resin composition "CR607" (trade name) manufactured by PPG Industries., Inc., to prepare a heat curable resin material, which was injected to a mould inside with injection pressure of 50 MPA, moulding was conducted by heating at 160 °C for 5 minutes. An adding amount of the thickening agent was adjusted so as to have viscosity of the resin material of 80 mPa·s under measuring condition at 23 °C and 500 Hz.

EXAMPLE (3)

Acryl oligomer type thickening agent "ELVACITE" (trade name) manufactured by E. I. du Pont de Nemours and Company was added to an allyl ester type resin composition "CR607" (trade name) manufactured by PPG Industries., Inc., to prepare a heat curable resin material, which was injected to a mould inside with injection pressure of 50 MPA, moulding was conducted by heating at 160 °C for 5 minutes. An adding amount of the thickening agent was adjusted so as to have viscosity of the resin material of 100 mPa·s under measuring condition at 23°C and 500 Hz.

EXAMPLE (4)

Acryl oligomer type thickening agent "ELVACITE" (trade name) manufactured by E. I. du Pont de Nemours and Company was added to an allyl ester type resin composition "DD201" (trade name) manufactured by Showa Denko K.K., to prepare a heat curable resin material, which was injected to a mould inside with injection pressure of 50 MPA, moulding was conducted by heating at 160°C for 5 minutes. An adding amount of the thickening agent was adjusted so as to have viscosity of the resin material of 4,000 mPa·s under measuring condition at 23 °C and 500 Hz.

EXAMPLE (5)

Acryl oligomer type thickening agent "ELVACITE" (trade name) manufactured by E. I. du Pont de Nemours and Company was added to an allyl ester type resin composition "DD201" (trade name) manufactured by Showa Denko K.K., to prepare a heat curable resin material, which was injected to a mould inside with injection pressure of 50 MPA, moulding was conducted by heating at 160°C for 5 minutes. An adding amount of the thickening agent was adjusted so as to have viscosity of the resin material of 9,000 mPa·s under measuring condition at 23°C and 500 Hz.

EXAMPLE (6)

Acryl oligomer type thickening agent "ELVACITE" (trade name) manufactured by E. I. du Pont de Nemours and Company was added to an allyl ester type resin composition "DD201" (trade name) manufactured by Showa Denko

K.K., to prepare a heat curable resin material, which was injected to a mould inside with injection pressure of 50 MPA, moulding was conducted by heating at 160 °C for 5 minutes. An adding amount of the thickening agent was adjusted so as to have viscosity of the resin material of 12,000 mPa·s under measuring condition at 23°C and 500 Hz.

EXAMPLE (7)

Silicone type resin composition "SR7010" (trade name) manufactured by Dow Corning Toray Co., Ltd., was employed as a heat curable resin material, it was injected to a mould inside with injection pressure of 50 MPA, and moulding was conducted by heating at 160°C for 5 minutes. Viscosity of the resin material was 18,000 mPa·s under measuring condition at 23°C and 500 Hz.

EXAMPLE (8)

Silicone type heat curable resin composition "LPS402" (trade name) manufactured by Shin-Etsu Chemical Co., Ltd. was employed as a resin material, it was injected to a mould inside with injection pressure of 50 MPA, and moulding was conducted by heating at 160 °C for 5 minutes. Viscosity of the resin material was 45,000 mPa·s under measuring condition at 23°C and 500 Hz.

COMPARATIVE EXAMPLE (1)

Silicone type resin composition "SR7010" (trade name) manufactured by Dow Corning Toray Co., Ltd., was employed as a heat curable resin material, it was injected to a mould inside with injection pressure of 50 MPA, and moulding was conducted by heating at 160 °C for 5 minutes. Viscosity of the resin material was 30 mPa·s under measuring condition at 23 °C and 500 Hz.

COMPARATIVE EXAMPLE (2)

Fumed silica was added as a thickening agent to silicone type heat curable resin composition "LPS402" (trade name) manufactured by Shin-Etsu Chemical Co., Ltd., to prepare a heat curable resin material, which was injected to a mould inside with injection pressure of 50 MPA, and moulding was conducted by heating at 160 °C for 5 minutes. An adding amount of the thickening agent was adjusted so as to have viscosity of the resin material of 60,000 mPa·s under measuring condition at 23°C and 500 Hz.

(EVALUATION OF DEFORMATION)

Each mould body of Examples (1) to (8) and Comparative Examples (1) and (2) manufactured above, was subjected to performing of a reflow process, and difference of surface form before and after the reflow process was evaluated by measuring via a 3-dimensional measuring device (UA3P, manufactured by Matsushita Electric Co., Ltd.). The result is summarized in Table 1 shown below. Designations in the Table are based on the following norm. The reflow process was conducted under a condition shown by continuous line at upper portion of Fig. 4. Practically, in Fig. 4 "average run up velocity (velocity from $Ts_{max}$ to Tp)" was set as 3 °C/sec at maxima, "preheat minimum temperature ($Ts_{min}$)" was set as 150 °C, "preheat maximum temperature ($Ts_{max}$)" was set as 200 °C, "preheat time (time from $ts_{min}$ to $ts_{max}$))" was set as 60 to 180 seconds, "retention temperature ($T_L$))" was set as 217 °C, "retention time ($t_L$))" was set as 60 to 150 seconds, "peak temperature ($T_P$))" was set as 260 °C, "peak time (tp))" was set as 20 to 40 seconds, "lamp down velocity")" was set as 6 °C /sec at maxima, and "time from 25°C to peak temperature" was set as at most 8 minutes.

Table 1

| Sample | Resin material | viscosity (mPa·s) | Deformation before and after reflow |
|---|---|---|---|
| Example (1) | CR607 (PPG), Thickening agent | 60 | B |
| Example (2) | CR607 (PPG), Thickening agent | 80 | A |
| Example (3) | CR607 (PPG), Thickening agent | 100 | A |
| Example (4) | DD201 (Showa Denko), Thickening agent | 4,000 | A |

(continued)

| Sample | Resin material | viscosity (mPa·s) | Deformation before and after reflow |
|---|---|---|---|
| Example (5) | DD201 (Showa Denko), Thickening agent | 9,000 | A |
| Example (6) | DD201 (Showa Denko), Thickening agent | 12,000 | B |
| Example (7) | SR7010 (Dow Corning Toray) | 18,000 | B |
| Example (8) | LPS402 (Shin-Etsu Chemical) | 45,000 | B |
| Comparative Example (1) | CR607 (PPG) | 30 | C |
| Comparative Example (2) | LPS402 (Shin-Etsu Chemical) | 60,000 | C |
| A: Difference of form (difference of surface form) is not more than 200 nm.<br>B: Difference of form (difference of surface form) is more than 200 and not more than 500 nm.<br>C: Difference of form (difference of surface form) is more than 500 nm. | | | |

(Conclusion)

Resin materials of Examples (1) to (8) are difficult to deform bay reflow process, and the optical elements composed of the resin material used in the Examples (1) to (8) are available to produce the image pick-up device mounting on a substrate together with the electronic parts.

**Claims**

1. A manufacturing method of an image pick-up device which comprises;
a step of forming an optical element by curing a thermosetting resin material having viscosity of 50 to 50,000 mPa·s under measuring condition at 23 °C and 500 Hz,
a step of placing an optical element and electronic parts on a substrate, and
a step of performing a reflow process to the optical element, the electronic parts and the substrate so as to mount the electronic parts and the substrate on the substrate.

2. An image pick-up device manufactured by the manufacturing method of claim 1.

3. An optical element
which is formed by curing a thermosetting resin material having viscosity of 50 to 50,000 mPa·s under measuring condition at 23 °C and 500 Hz, and is to be used in a manufacturing method in which the optical element and the electronic parts are mounted on the substrate by a reflow process in a state that the optical element and the electronic parts are placed on the substrate.

FIG. 1

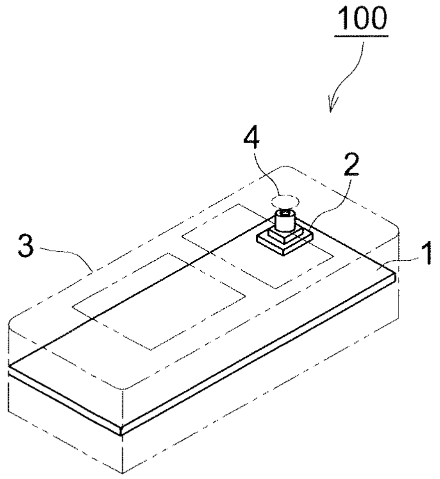


FIG. 2

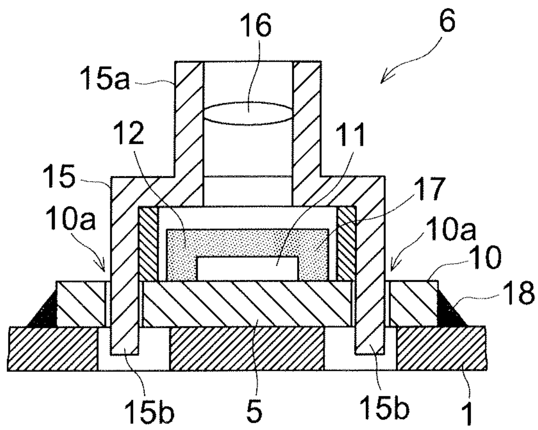

FIG. 3a

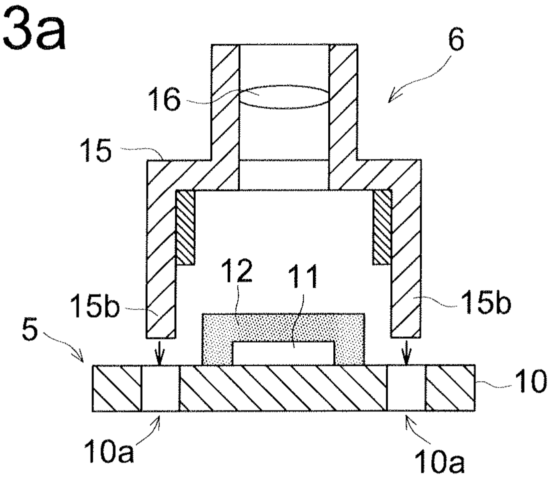


FIG. 3b

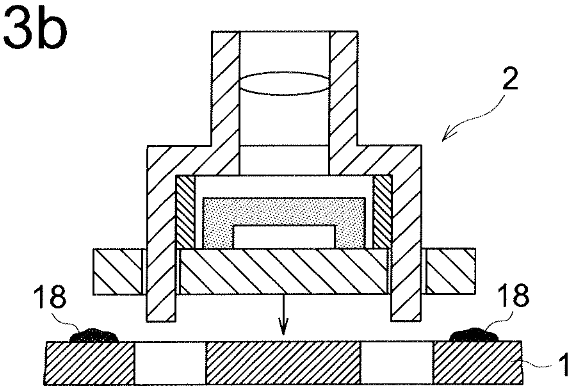


FIG. 3c

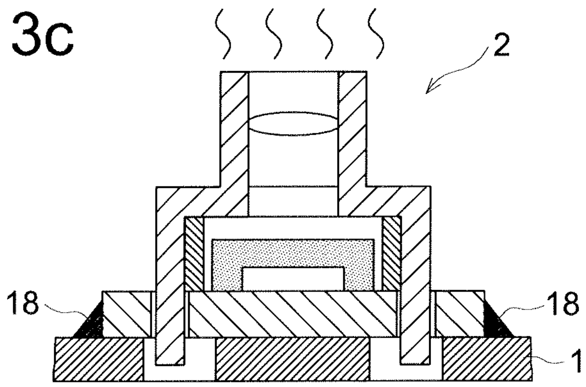

FIG. 4

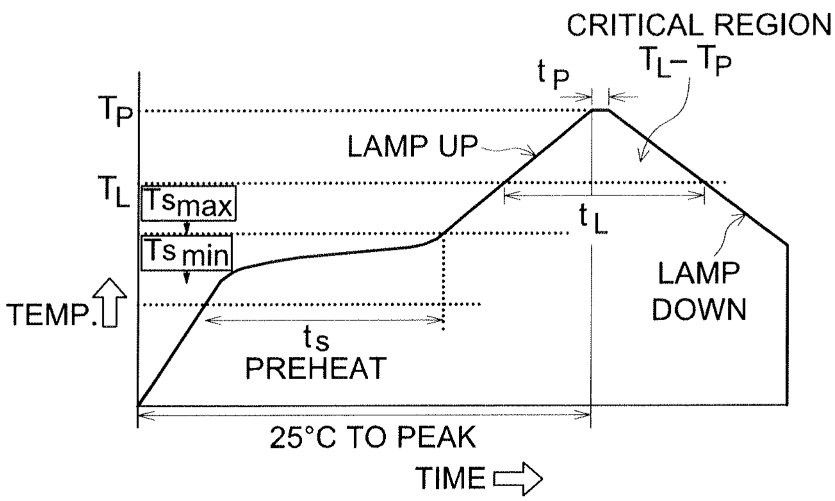
CRITICAL REGION
$T_L$– $T_P$
$t_P$
$T_P$
LAMP UP
$T_L$
$Ts_{max}$
$Ts_{min}$
$t_L$
LAMP
DOWN
TEMP.
$t_s$
PREHEAT
25°C TO PEAK
TIME

**INTERNATIONAL SEARCH REPORT**

International application No.
PCT/JP2008/061224

A. CLASSIFICATION OF SUBJECT MATTER
*G02B7/02*(2006.01)i, *G02B1/04*(2006.01)i, *H01L27/14*(2006.01)i, *H04N5/225*(2006.01)i, *H04N5/335*(2006.01)i

According to International Patent Classification (IPC) or to both national classification and IPC

B. FIELDS SEARCHED

Minimum documentation searched (classification system followed by classification symbols)
G02B7/02, G02B1/04, H01L27/14, H04N5/225, H04N5/335

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 11-160503 A (Shin-Etsu Polymer Co., Ltd.), 18 June, 1999 (18.06.99), Claim 1; Par. No. [0022] (Family: none) | 1-3 |
| A | JP 2004-117955 A (Nippon Telegraph And Telephone Corp.), 15 April, 2004 (15.04.04), Table 2 (Family: none) | 1-3 |
| A | JP 2004-004632 A (Teijin Chemicals Ltd.), 08 January, 2004 (08.01.04), Full text & US 2005/0119441 A1 & EP 1489123 A1 & WO 2003/082951 A1 | 1-3 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 14 July, 2008 (14.07.08) | 22 July, 2008 (22.07.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001024320 A
- JP H1174420 A
- JP 2004307011 A
- JP 2004186168 A
- JP 2003066201 A
- JP 2006131876 A
- JP 2006335894 A


### Non-patent literature cited in the description


- **Baifukan.** Butsurigaku Jiten. 30 November 1989
- Butsurigaku Jiten. Baifukan, 30 November 1989
- Iwanami Rikagaku Jiten. 01 June 1977